# EUROPEAN PATENT SPECIFICATION

(11) **EP 3 637 576 B1**
(45) Date of publication and mention of the grant of the patent: **27.10.2021**
(21) Application number: 18798986.8
(22) Date of filing: 08.05.2018
(51) Int. Cl.: H02J 7/00, G01R 19/00, G01R 19/155, H02M 3/00, H02J 50/00

(54) **CHARGING AND DISCHARGING CIRCUIT, CAPACITOR UNIT, AND ELECTROSCOPE**
LADE- UND ENTLADESCHALTUNG, KONDENSATOREINHEIT UND ELEKTROSKOP
CIRCUIT DE CHARGE ET DE DÉCHARGE, UNITÉ DE CONDENSATEUR ET ÉLECTROSCOPE

(30) Priority: 10.05.2017 JP 2017093702; 10.05.2017 JP 2017093703; 06.06.2017 JP 2017111294
(43) Date of publication of application: 15.04.2020
(73) Proprietor: Wave Energy Inc., Tokyo 105-0014 (JP)
(72) Inventor: HONKE Masao, Mitoyo-shi Kagawa 769-1102 (JP); SASAKI Makoto, Tokyo 105-0014 (JP)
(74) Representative: Liedtke & Partner Patentanwälte
(86) International application number: PCT/JP2018/017727
(87) International publication number: WO 2018/207761

(56) References cited:
- WO-A2-2013/118116
- JP-A- S6 114 576
- JP-A- 2000 088 892
- JP-A- 2003 047 236
- JP-A- 2010 175 596
- JP-A- 2010 175 596
- JP-U- S 581 168
- JP-U- S6 217 773
- JP-Y2- S56 037 723
- US-A1- 2003 102 961
- US-A1- 2009 067 208
- US-A1- 2011 175 461

## Description

### [TECHINICAL FIELD]

A present invention relates to a charging and discharging circuit which charges input electric current to capacitors and discharges output electric current from the capacitors, and an electroscope which comprises the charging and discharging circuit and inspects energization of electric path using the output electric current discharged from the charging and discharging circuit.

### [BACKGROUND ART]

Hitherto, a capacitor charging device which charges a capacitor (in detail, the capacitor charging device which charge the capacitor, which applies power supply voltage to circuit that can connect switching means which switches on in accordance with a switch drive signal to a primary winding of a transformer in series, and can connect to a secondary winding of the transformer) is known (refer to patent document 1).

The capacitor charging device comprises primary electric current detection means, which detects primary electric current detection signal in accordance with primary electric current which is made to flow to the primary winding, at the time that the switch drive signal is generated and the switching means is switched on, a primary electric current detection circuit, which generates the primary electric current detection signal for stopping the switch drive signal and switching off the switching means, at the time that the primary electric current detection signal reaches a predetermined value for peak detection, and off time detection circuit, which generates off time terminate signal for generating the switch drive signal and switching on the switching means, at the time that starts clocking of the off time in response to the primary electric current detection signal and clocks the off time.

Hitherto, an electric double layer capacitor is known (refer to patent document 2).

The capacitor is electric double layer capacitor which comprises a pair of polarizable electrodes placed opposite to in electrolysis liquid and a pair of conductive electrodes connecting to outer face of each the polarizable electrode, the capacitor forms a pair of electrode unit unified conductive electrode and polarizable electrode, the capacitor holds each electrode unit by a regulating member in place.

### [PRIOR ART]

### [PATENT DOCUMENT]

[PATENT DOCUMENT 1] Japanese Patent Application Laid Open No.2000-184527
[PATENT DOCUMENT 2] Japanese Patent Application Laid Open No.H5-159975

JP 2010 175596 A discloses that, when charging capacitors with large capacitance and being first and second capacitors with large capacitance, both capacitors with large capacitance are charged in parallel from a power supply for output of a voltage lower than a voltage necessary for driving a flash LED by a first switching state of switching parts and. When making the flash LED being a load that causes flow of comparatively high current instantaneously emit light, both capacitors with large capacitance are separated from the power supply, and also they are connected to each other in series to drive the flash LED by a second switching state of the switching parts. The second switching state is restored to the first switching state when charging voltage of the second capacitor with large capacitance drops to predetermined voltage or when predetermined time elapses.

### [SUMMARY]

### [PROBLEM TO BE SOLVED]

However, the capacitor charging device disclosed in patent document 1, in the first place, essentially comprises, in addition to the transformer, the primary electric current detection means detecting the primary electric current detection signal, the primary electric current detection circuit generating the primary electric current detection signal, and, the off time detection circuit generating the off time terminate signal too, complication and upsizing of the device is caused (in particular, figure 1 of patent document 1).

And, however, in the capacitor disclosed in patent document 2, both the one pair of the polarizable electrodes is a flatplate-like shape (figures 1, 2, 4, 7 of patent document 2), the one pair of the polarizable electrodes is placed parallelly (paragraph 0016, 0029 of patent document 2), for example, if it makes the one pair of the polarizable electrodes positioned in electric field already generated (the electric field and so on generated by high voltage electric current being made to flow near electric path), sufficient electric potential difference is not generated between these pair of the polarizable electrodes, if this electric potential difference is used, it is difficult to make element of LED and so on driving.

Furthermore, the capacitor disclosed in patent document 2 essentially comprises the regulating member which is plurality of insulating bridges and so on placed between the one pair of the polarizable electrodes, it also can be said that increase in number of components and complication as the capacitor is caused (claims 1, 2 and figures 1, 4, 7 et cetera of patent document 2).

The present invention, in view of the problems like these, aims to provide a charging and discharging circuit and an electroscope which can realize "simplification" and so on, according to comprising change-over switches which can switch how to flow electric current to plurality of capacitors in series and in parallel, in addition, comprising a discharge switch which starts discharging from the plurality of the capacitors too.

And, the present invention, in view of the problems like these, aims to provide an electroscope which can realize "increase in acquired electric potential difference" et cetera between electrodes in a predetermined electric field, according to providing a non-parallel part stood on end of body parts of electrodes.

Furthermore, it also can be said that the present invention aims to provide an electroscope which can realize "reduction in number of components" and "simplification" and so on.

### [SOLUTION]

The charging and discharging circuit 1 of the present invention is, wherein the charging and discharging circuit charges input electric current X to a plurality of capacitors 2, the charging and discharging circuit discharges output electric current Y from the plurality of the capacitors 2; the charging and discharging circuit comprises change-over switches 3 which are switchable to a series electric current state J1, in which the electric current flows to the plurality of the capacitors 2 in series, and a parallel electric current state J2, in which the electric current flows to the plurality of the capacitors 2 in parallel; the charging and discharging circuit comprises, apart from the change-over switches 3, a discharge switch 4 which starts a discharging of the output electric current Y from the plurality of the capacitors 2 too, the 1st characterized by the following; the charging and discharging circuit comprises a series wiring 5 which connects to the plurality of the capacitors 2 in series; the charging and discharging circuit comprises intermediate diodes 6 which are arranged between each set of adjacent two capacitors 2 and are aligned in a forward direction from an anode to a cathode in the series wiring 5; the charging and discharging circuit comprises anode parallel wirings 9A connecting each anode-capacitor interval 7A between the anode side of the intermediate diode 6 and the capacitor adjacent to the anode side, to a cathode end outside electrode 8K which is positioned on the end of the series wiring 5 and is positioned on the opposite side of the intermediate diode in a cathode end capacitor 2K adjacent to only the cathode side of the intermediate diode 6; the charging and discharging circuit comprises cathode parallel wirings 9K connecting each cathode-capacitor interval 7K between the cathode side of the intermediate diode 6 and the capacitor adjacent to the cathode side, to an anode end outside electrode 8A which is positioned on the end of the series wiring 5 and is positioned on the opposite side of the intermediate diode in an anode end capacitor 2A adjacent to only the anode side of the intermediate diode 6;the charging and discharging circuit has a case that the change-over switches 3 are arranged in the anode parallel wirings 9A, diodes for parallel 10 are arranged in a forward direction from the cathode-capacitor interval 7K to the anode end outside electrode 8A in the cathode parallel wirings 9K, a case that the change-over switches 3 are arranged in the cathode parallel wirings 9K, diodes for parallel 10 are arranged in a forward direction from the cathode end outside electrode 8K to the anode-capacitor interval 7A in the anode parallel wirings 9A, or, a case that the change-over switches 3 are arranged in the anode parallel wirings 9A and the cathode parallel wirings 9K.

The 2nd characteristic of the charging and discharging circuit 1 of the present invention is, in addition to the above 1st characteristics, the charging and discharging circuit comprises a timer part 11 which periodically performs switching by the change-over switches 3 and starting by the discharge switch 4; the charging and discharging circuit comprises a timer power supply wiring 13 connecting the power supply terminal 12 of the timer part 11 to a diode-capacitor interval 7D between the cathode end capacitor 2K or the anode end capacitor 2A and the intermediate diode 6 adjacent to the capacitors 2K,2A; the charging and discharging circuit comprises a diode for power supply 14 which is arranged in a forward direction from the diode-capacitor interval 7D to the power supply terminal 12 in the timer power supply wiring 13.

Owing to the characteristics, unlike patent document 1, it becomes possible to transformation from high voltage to low voltage and/or from low voltage to high voltage by the change-over switches 3, a transformer which increases weight and size by iron core and coil et cetera, becomes unnecessary, there is only the discharge switch 4 other than the change-over switches 3, it can restrain the condition of being numerous in variety in the circuit than to use the primary electric current detection means, the primary electric current detection circuit, and, the off time detection circuit and so on (realization of "the simplification"), according to comprising, apart from the change-over switches 3 which are switchable to the series electric current state J1 and the parallel electric current state J2, the discharge switch 4 to start the discharging from the plurality of the capacitors 2.

And, it becomes possible to switch the electric current being made to flow to each capacitor 2 from series to parallel, from parallel to series by the change-over switches 3, without changing actual connecting constitution of the plurality of the capacitors 2, and also, it can suppress voltage drop just as much as arranging the change-over switches 3 in the one of the anode parallel wirings 9A and the cathode parallel wirings 9K than a case of arranging the diodes for parallel 10 in both wirings, according to arranging the intermediate diode 6 between adjacent two capacitors 2 in the series wiring 5 connecting to the plurality of the capacitors 2 in series, and arranging the change-over switches 3 in at least the one of the anode parallel wirings 9A and the cathode parallel wirings 9K, in addition to arranging the diodes for parallel 10.

Moreover, it becomes possible to switch the electric current being made to flow to each capacitor 2 from parallel to series, from series to parallel by the change-over switches 3, without changing actual connecting constitution of the plurality of the capacitors 2, and also, it can suppress voltage drop just as much as arranging the change-over switches 3 in the one of the anode parallel wirings 9A' and the cathode parallel wirings 9K' than a case of arranging the diodes for parallel 10' in both wirings, according to arranging the intermediate diode 6' between adjacent two capacitors 2 in the series wiring 5' connecting to the plurality of the capacitors 2 in series, and arranging the change-over switches 3 in at least the one of the anode parallel wirings 9A' and the cathode parallel wirings 9K', in addition to arranging the diodes for parallel 10'.

Then, it can prevent to flow back electric current from the power supply terminal 12 side of the timer part 11 to the capacitors 2 side, even in a case that voltage of the capacitors 2 decreases by discharging from the plurality of the capacitors 2, there is no trouble in operation of the timer part 11, according to arranging the diode for power supply 14 in the timer power supply wiring 13.

The electroscope 20 of the present invention is the 1st characterized by the following; the electroscope comprises the charging and discharging circuit 1 having the above-mentioned 1st or 2nd characteristics, the electroscope inspects energization of electric path R using output electric current Y discharged from the charging and discharging circuit 1; the electroscope comprises a pair of gate electrodes 21 which connecting to the anode end outside electrode 8A and the cathode end outside electrode 8K of the charging and discharging circuit 1; the electroscope charges the input electric current X by electric potential difference between the one pair of gate electrodes 21 to the plurality of the capacitors 2, at the time of making the one pair of gate electrodes 21 positioned in electric field E generated by the energization of the electric path R; the electroscope comprises a light-emitting part 22 which flickers by the output electric current Y discharged periodically from the plurality of the capacitors 2.

The 2nd characteristic of the electroscope 20 of the present invention is, in addition to the above 1st characteristic, the electric path R is an alternating electric path R'; the electroscope comprises rectifiers 23 which convert alternating electric current from the alternating electric path R' to direct electric current; the electroscope charges the direct electric current from the rectifiers 23 to the plurality of the capacitors 2 as the input electric current X; the electroscope switches the series electric current state J1 at the time of charging to the plurality of the capacitors 2 by the change-over switches 3, the electroscope switches the parallel electric current state J2 before discharging from the plurality of the capacitors 2 by the change-over switches 3; the electroscope starts to discharge the output electric current Y by the discharge switch 4 after switching the parallel electric current state J2.

Owing to the characteristics, there is no fear of being not able to perform voltage checking and electric continuity checking et cetera by powering off the power supply, because another power supply is not necessary, it can attain further "the simplification", according to charging the input electric current X from between the gate electrodes 21 positioning in electric field E generated by the energization of the electric path R, to the plurality of the capacitors 2, comprising the light-emitting part 22 which flickers by the output electric current Y periodically discharged from the plurality of the capacitors 2.

In addition to this, it can reduce electric power required for the light-emitting part 22 just as much as existing time which the light-emitting part 22 lights off ("electric power saving"), and also, in a result, the light-emitting part 22 lasts long because of shortening the light-emitting time ("prolonging of lifetime").

And, it becomes to discharge as low electric potential certainly, after charging and completing to switch from series to parallel, even for high electric potential direct electric current rectified form alternating electric path R', it becomes possible to perform electric detection without imposing overloads to the light-emitting part 22, even the alternating electric path R' is high voltage (for example, 6600V, 22000V and so on), according to rectifying the alternating electric current from the alternating electric path R' by the rectifier 23, charging the alternating electric current to the plurality of the capacitors 2, and starting to discharge the output electric current Y after switching to the series electric current state J1 at the time of charging the plurality of the capacitors 2, and switching to the parallel electric current state J2 before discharging.

Besides, the 3rd characteristic of the electroscope 20 of the present invention is, in addition to the above 1st or 2nd characteristics, the electroscope comprises a capacitor unit 101 having the one pair of electrodes 102, the electroscope charges the electric current of the capacitor unit 101 to the plurality of the capacitors 2 of the charging and discharging circuit 1 having the above-mentioned 3rd characteristic, the electroscope inspects the energization of electric path R; both the electrodes 102 of the pair of capacitor unit 101 respectively comprise a body part 103 being almost parallel mutually; the one or the both of the one pair of the electrodes 102 comprise a non-parallel part 104 which stands toward the other electrode side on the end of the body part 103, and is not almost parallel to the other electrode.

Besides, the capacitor unit 101 of the present invention may be the characterized by the following; the capacitor unit comprises a pair of electrodes 102; both the electrodes 102 of the pair of the capacitor unit 101 respectively comprise a body part 103 being almost parallel mutually; the one or the both of the one pair of the electrodes 102 comprise a non-parallel part 104 which stands toward the other electrode side on the end of the body part 103, and is not almost parallel to the other electrode.

Furthermore, "the other electrode" in the present invention, based on view point of the one electrode 102a, means "the other electrode 102b", and based on view point of the other electrode 102b, means "the one electrode 102a". That is, "the other electrode" means the other electrode placed opposite mutually.

Besides, the capacitor unit 101 not according to the present invention may be the capacitor unit comprises a casing 105 holding the a pair of the electrodes 102; the casing 105 comprises a pair of body side parts 106 holding the body part 103 of each electrode 102 of the pair, and a joint side part 107 which stands the end of each body side part 106 and joins together between the one pair of the body side parts 106; the capacitor unit has a case that the one of the one pair of the electrodes 102 is a coated electrode 102' constituted to coat conductive material on the inner face of the casing 105, and the other of the one pair of the electrodes 102 is constituted by a metal plate 102", or, a case that the both of the one pair of the electrodes 102 are coated electrodes 102' constituted to coat conductive material on the inner face of the casing 105; in the case of the coated electrode 102' comprises the body part 103 and the non-parallel part 104, the body part 103 is constituted to coat conductive material on the inner face of the body side part 106 of the casing 105, the non-parallel part 104 is constituted to coat conductive material on the inner face of the joint side part 107 of the casing 105, in the case of the coated electrode 102' comprises only the body part 103, the body part 103 is constituted to coat conductive material on only the inner face of the body side part 106 of the casing 105.

Owing to the characteristics, unlike patent document 2, it provides the capacitor unit which can realize to generate electric potential difference sufficiently between the one pair of the electrodes 102("increase in acquired electric potential difference"), even in a predetermined electric field E (for example, an electric field E and so on generated by energization of electric path R described later), according to providing the body parts 103 which are almost parallel mutually in both the electrodes 102 of the pair, and providing the non-parallel parts 104 which stand toward the other electrode side on end of the body parts 103 and are not almost parallel to the other electrode, in at least the one of the one pair of the electrodes 102.

Furthermore, unlike patent document 2, it can realize the reduction of the number of components and the simplification as the capacitor unit 101, because the regulating member, which is insulating bridge and so on, is not essential (realization of "the reduction of the number of components" and "the simplification").

And, necessary space becomes only coating thickness of the conductive material for providing the electrodes 102, it can attain downsizing than a case of providing the metal plate 102"at both the electrodes 102, because some of the metal plate 102"different from the casing 105 is non-bulky, according to providing the one pair of the body side part 106 holding the body part 103 of each electrode 102 and the joint side part 107 standing from end of each body side part 106 and joining together between the one pair of the body side parts 106, at the casing 105 holding the one pair of the electrodes 102, and constituting at least the one of the one pair of the electrodes 102, of the coated electrode 102' coating the conductive material on the inner face of the casing 105.

Besides, the capacitor unit 101 not according to the present invention may be the conductive material is coated on the inner face of the casing 105 by vapor deposition.

Besides, the electroscope 110 not according to the present invention may be the characterized by the following; the electroscope comprises the capacitor unit 101 described in any one of claims 8 to 10, the electroscope inspects energization of electric path R using electric current from the capacitor unit 101; the electroscope comprises a light-emitting part 111 which lights on by electric current generated by electric potential difference between the one pair of the electrodes 102 of the capacitor unit 101, at the time of making the electroscope positioned in electric field E generated by the energization of the electric path R; the casing 105 of the capacitor unit 101 is used also as the casing 112 of the electroscope.

The electroscope 110 not according to the present invention may be the one of the one pair of the electrodes 102 is a coated electrode 102' comprising a body part 103 and a non-parallel part 104, the other is a metal plate 102"comprising only a body part 103; the one coated electrode 102' of the one pair of the electrodes 102 is positioned farther than the other metal plate 102"from the electric path R; the body part 103 of the one coated electrode 102' of the one pair of the electrodes 102 is almost the same size as or greater than the body part 103 of the other metal plate 102".

The electroscope 110 not according to the present invention may be the electric path R comprises a longer direction L; the electroscope charges electric current from the capacitor unit 101 to an electric storage device 132, the electroscope comprises a charging and discharging circuit 131 which makes the light-emitting part 111 lights on by electric current discharged from the electric storage device 132; in the circuit board 133 of the charging and discharging circuit 131, the wirings almost parallel to the longer direction L of the electric path R is fewer than the wirings not almost parallel to the longer direction L of the electric path R.

Besides, the electroscope 110 not according to the present invention may be the characterized by the following; the electroscope comprises a casing 105 holding the a pair of the electrodes 102; the electroscope has a case that the one of the one pair of the electrodes 102 is a coated electrode 102' constituted to coat conductive material on the inner face of the casing 105, and the other of the one pair of the electrodes 102 is constituted by a metal plate 102", or, a case that the both of the one pair of the electrodes 102 are coated electrodes 102' constituted to coat conductive material on the inner face of the casing 105; the conductive material is coated on the inner face of the casing 105 by vapor deposition; the electroscope inspects energization of electric path R using electric current from the capacitor unit 101; the electroscope comprises a light-emitting part 111 which lights on by electric current generated by electric potential difference between the one pair of the electrodes 102 of the capacitor unit 101, at the time of making the electroscope positioned in electric field E generated by the energization of the electric path R; the casing 105 of the capacitor unit 101 is used also as the casing 112 of the electroscope; the electric path R comprises a longer direction L; the electroscope charges electric current from the capacitor unit 101 to an electric storage device 132, the electroscope comprises a charging and discharging circuit 131 which makes the light-emitting part 111 lights on by electric current discharged from the electric storage device 132; in the circuit board 133 of the charging and discharging circuit 131, the wirings almost parallel to the longer direction L of the electric path R is fewer than the wirings not almost parallel to the longer direction L of the electric path R.

Owing to the characteristics, as compared with patent document 2, it becomes large that the electric potential difference between the one pair of the electrodes 102 in the electric field E generated by the energization of the electric path R just as much as comprising the non-parallel part 104, it is easy to transmit the energization of the electric path R to user as the electroscope 110 because of lighting on the light-emitting part 111 brighter, according to comprising the light-emitting part 111 which lights on by electric current from between the one pair of the electrodes 102 positioning in the electric field E generated by the energization of the electric path R, and being used the casing 105 of the capacitor unit 101 also as the casing 112 of the electroscope 110.

At the same time of this, it can realize the downsizing because it is not necessary to severally provide the casing 112 of the electroscope 110 and the casing 105 of the capacitor unit 101.

And, it can capture the electric field E, which is generated by the energization of the electric path R and spreads as going away from the electric path R, without more omission, by the coated electrode 102' positioned at a side far from the electric path R, it also can attain the downsizing (achieving both further "the increase in the acquired electric potential difference" and "the downsizing"), according to the one of the one pair of the electrodes 102's being the coated electrode 102' comprising the body part 103 and the non-parallel part 104, the other's being the metal plate 102"comprising only the body part 103, the one coated electrode 102' s being positioned farther than the other metal plate 102"from the electric path R, and the body part 103 of the one coated electrode 102's being almost the same size as or greater than the body part 103 of the other metal plate 102".

At the same time of this, it becomes that the electrodes 102 of the metal plate 102"supports the electroscope 110 from a side near side of the electric path R, it becomes easy to firmly fix the electroscope 110 to the electric path R.

Moreover, a parasitic capacitance, which is generated between the electric path R, and wirings almost parallel to a longer direction L of the electric path, is reduced, it can suppress the influence, according to, in the circuit board 133 of the charging and discharging circuit 131, the wirings almost parallel to the longer direction L of the electric path R's being fewer than the wirings not almost parallel to the longer direction L of the electric path R.

### [EFFECT OF THE INVENTION]

The charging and discharging circuit and the electroscope of the present invention can realize "the simplification" et cetera, according to the comprising change-over switches which can switch how to flow electric current to plurality of capacitors in series and in parallel, in addition, comprising the discharge switch which starts discharging from the plurality of the capacitors too.

And, the capacitor unit and the electroscope of the present invention can realize "the increase in the acquired electric potential difference" et cetera between the electrodes in the predetermined electric field, according to providing the non-parallel part stood on the end of the body parts of electrodes.

Furthermore, the capacitor unit and the electroscope of the present invention can realize "the reduction in the number of components" and "the simplification" and so on, too.

### [BRIEF DESCRIPTION OF THE DRAWINGS]

[FIGURE 1] Figure 1 shows a circuit diagram of the charging and discharging circuit of the 1st embodiment of the present invention, and the electroscope of the 1st embodiment of the present invention.
[FIGURE 2] Figure 2 shows an equivalent circuit diagram exemplified the charging and discharging circuit, and Figure 2(a) exemplifies the charging and discharging circuit at the time of charging, Figure 2(b) exemplifies the charging and discharging circuit at the time of discharging.
[FIGURE 3] Figure 3 shows an equivalent circuit diagram exemplified a connecting example of the plurality of the capacitors of the charging and discharging circuit.
[FIGURE 4] Figure 4 shows a timing chart of each signal of the timer part of the charging and discharging circuit.
[FIGURE 5] Figure 5 shows a circuit diagram of the charging and discharging circuit of the 2nd embodiment of the present invention, and the electroscope of the 2nd embodiment of the present invention.
[FIGURE 6] Figure 6 shows a schematic view exemplified a circuit board layout of the electroscope, and Figure 6(a) shows a silk/resist diagram of a components face, Figure 6(b) shows a pattern diagram of a components face, Figure 6(c) shows a pattern diagram of a solder face.
[FIGURE 7] Figure 7 shows a schematic view exemplified a constitution component of the electroscope, and Figure 7(a) shows an exploded perspective view, Figure 7(b) shows a view taken in the direction of arrow M in Figure 7(a).
[FIGURE 8] Figure 8 shows a substitute photo for figure exemplified a mounting state for the electric path (a bus bar) of the electroscope.
[FIGURE 9] Figure 9 shows a substitute photo for figure of the electrode and the casing of the capacitor unit of the 1st embodiment of the present invention, and Figure 9(a) shows the casing and the electrode (the metal plate) of the capacitor unit, Figure 9(b) shows the inner of the casing face and the electrode (the coated electrode, the metal plate) of the capacitor unit.
[FIGURE 10] Figure 10 shows a sectional schematic view of the capacitor unit, and Figure 10(a) shows a section taken in the direction of arrow A in Figure 9(a) of the capacitor unit of the 1st embodiment, Figure 10(b) shows the 2nd embodiment.
[FIGURE 11] Figure 11 shows a section taken in the direction of arrow B in Figure 9(a) of the capacitor unit of the 1st embodiment.
[FIGURE 12] Figure 11 shows a circuit schematic view of the capacitor unit of the 1st, 2nd embodiments of the present invention, and the electroscope of the 2nd embodiment of the present invention.
[FIGURE 13] Figure 13 shows a schematic view exemplified a circuit board layout of the electroscope and a longer direction of the electric path, and Figure 13(a) shows a pattern diagram of a components face and a longer direction of the electric path, Figure 13(b) shows a pattern diagram of a solder face and a longer direction of the electric path.
[FIGURE 14] Figure 14 shows an exploded perspective view exemplified the constitution component of the electroscope.
[FIGURE 15] Figure 15 shows a schematic perspective view exemplified a mounting state for the electric path (a cable) of the electroscope, and Figure 15(a) shows an exploded perspective view, Figure 15(b) shows a front perspective view, Figure 15(c) shows a back perspective view.
[FIGURE 16] Figure 16 shows a schematic perspective view exemplified a mounting state for the electric path (a bus bar) of the electroscope, and Figure 16(a) shows an exploded perspective view, Figure 16(b) shows a front perspective view, Figure 16(c) shows a back perspective view.
[FIGURE 17] Figure 17 shows a substitute photo for figure exemplified a mounting state for the electric path (a bus bar) of the electroscope.
[FIGURE 18] Figure 18 shows an equivalent circuit diagram exemplified another connecting example of the plurality of the capacitors of the charging and discharging circuit.

### [MODES FOR CARRYING OUT THE INVENTION]

The embodiments of the present invention are explained to refer to the Figures below.

### <Charging and discharging circuit 1 of the 1st embodiment>

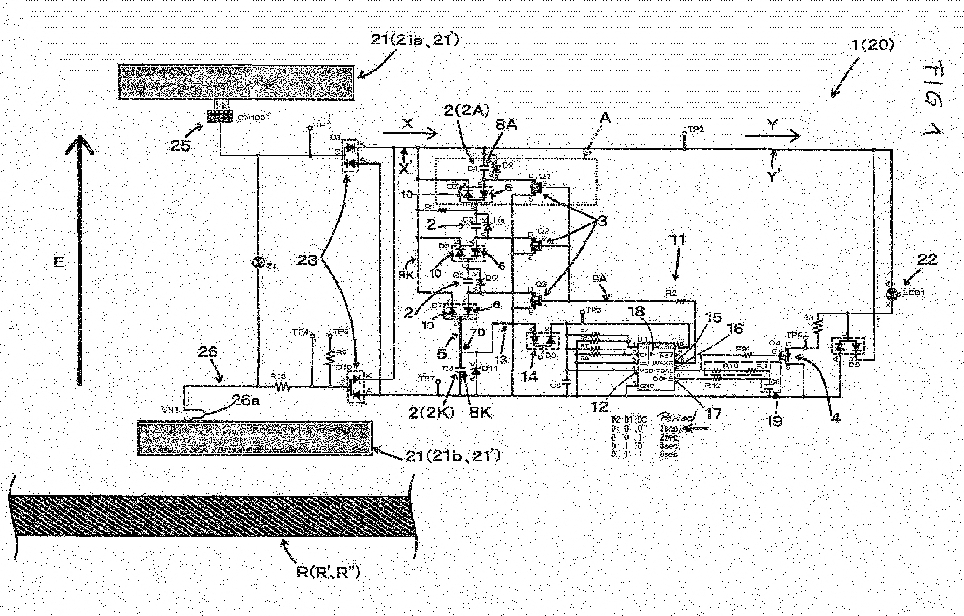

Figures 1 to 4 show the charging and discharging circuit 1 of the 1st embodiment of the present invention.

This charging and discharging circuit 1 is the circuit which charges an input electric current X to a plurality of capacitors 2, and discharges an output electric current Y from these plurality of the capacitors 2.

The charging and discharging circuit 1 comprises change-over switches 3, which is switchable to states J1, J2 that can flow an electric current to a plurality of capacitors 2, and a discharge switch 4, which starts discharging from the plurality of the capacitors 2.

And, the charging and discharging circuit 1 may comprise a series wiring 5, an intermediate diodes 6, anode parallel wirings 9A, cathode parallel wirings 9K, diodes for parallel 10, a timer part 11, a timer power supply wiring 13,and a diode for power supply 14 and so on.

### <Capacitor 2>

As shown in Figures 1 to 3, the capacitors 2 charges the input electric current X, discharges the output electric current Y, and it also can be said that the capacitors 2 is charge capacitors 2.

The capacitors 2 are plurality, the number of the capacitors 2 may be two, three, and four or more and so on, if the number is plurality, the number may be any value.

Each capacitor 2 may be connected in parallel Zener diode which generates a constant voltage at the time of applying voltage in an opposite direction.

A static capacitance of each capacitor 2 may be any value, for example, 2.2 micro-farads and so on in nominal value, and the static capacitance of each capacitor 2 may be almost the same value, may be different value.

The static capacitance of each capacitor 2 is not limited in particular, for example, may be more than 0.001 micro-farads and less than 10000.000 micro-farads, preferably may be more than 0.01 micro-farads and less than 5000.00 micro-farads, more preferably may be more than 0.1 micro-farads and less than 1000.00 micro-farads (100 micro-farads and so on).

Moreover, a dielectric, that relative dielectric constant is greater than 1, may be hold between the electrodes of the capacitors 2, the state between the electrodes may be the state that the relative dielectric constant is 1 (that is, the state that there is vacuum between the electrodes) and so on, the state between the electrodes may be any state.

Furthermore, each capacitor 2 may be what some of capacitor members gather.

### <Series wiring 5, Parallel wirings 9A, 9K and so on>

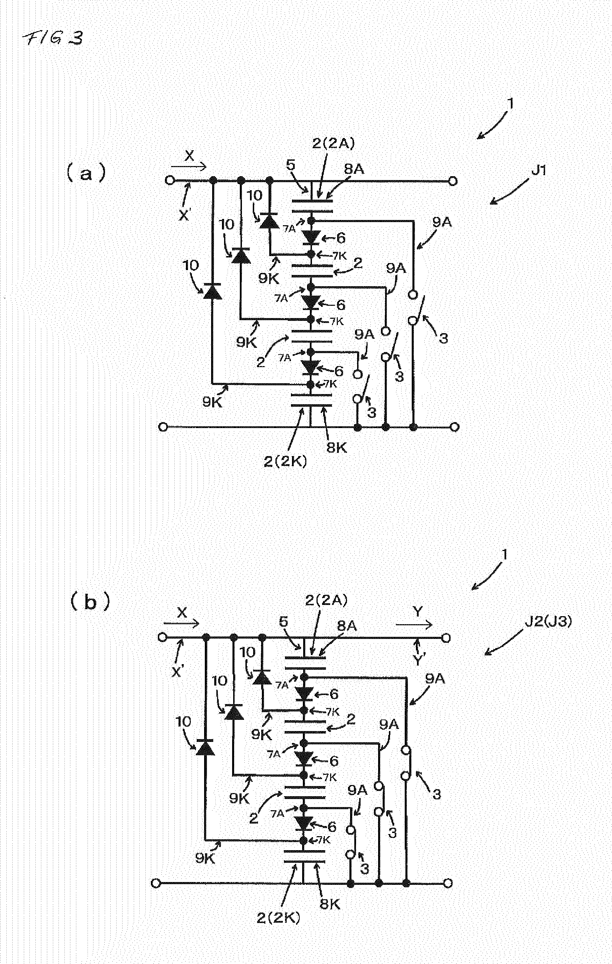

As shown in Figure 3 in particular, the series wiring 5 is a wiring connecting the plurality of the capacitors 2 in series, each between adjacent two capacitors 2 in the series wiring 5, intermediate diodes 6 are arranged to align in a forward direction from an anode to a cathode.

Furthermore, this each intermediate diode 6 may be one element and be independent of only intermediate diodes 6, the intermediate diodes 6 may be combined with diodes for parallel 10 described later, the intermediate diodes 6 and the diodes for parallel 10 may become one element.

The anode parallel wirings 9A are wirings connecting each anode-capacitor interval 7A between the anode side of each the above-mentioned intermediate diode 6 and the capacitor adjacent to the anode side, to a cathode end outside electrode 8K which is positioned on the end of the series wiring 5 and is positioned on the opposite side of the intermediate diode in a cathode end capacitor 2K adjacent to only the cathode side of the intermediate diode 6.

And, the cathode parallel wirings 9K are wirings connecting each cathode-capacitor interval 7K between the cathode side of each the intermediate diode 6 and the capacitor adjacent to the cathode side, to an anode end outside electrode 8A which is positioned on the end of the series wiring 5 and is positioned on the opposite side of the intermediate diode in an anode end capacitor 2A adjacent to only the anode side of the intermediate diode 6.

In the one of these two parallel wirings 9A, 9K, the change-over switches 3 are arranged, in the other, the diodes for parallel 10 are arranged.

That is, it becomes to exist three cases: <1> a case that, in the anode parallel wirings 9A, the change-over switches 3 are arranged, in the cathode parallel wirings 9K, the diodes for parallel 10 are arranged in a forward direction from the cathode-capacitor interval 7K to the anode end outside electrode 8A, <2> a case that, in the cathode parallel wirings 9K, the change-over switches 3 are arranged, in the anode parallel wirings 9A, the diodes for parallel 10 are arranged in a forward direction from the cathode end outside electrode 8K to the anode-capacitor interval 7A, or,<3> a case that, in the anode parallel wirings 9A and the cathode parallel wirings 9K, the change-over switches 3 are arranged (Figure 3 shows the case of <1>).

About the cases of <1>, <2>, in particular, of the above-mentioned cases <1> to <3>, we describe in more detail that a case that the number of the capacitors 2 is three or more, each the number of the parallel wirings 9A, 9K is two more than.

The cases of the above <1>, <2> include even a case that, regarding one charging and discharging circuit 1, in a anode parallel wiring 9A-1, the change-over switch 3 is arranged, and in a cathode parallel wiring 9K-1 which is the opposite side through an intermediate diode 6-1 adjacent to the anode parallel wiring 9A-1, the diode for parallel 10 is arranged. At the same time this, in another anode parallel wiring 9A-2, inversely the diode for parallel 10 is arranged, and in a cathode parallel wiring 9K-2 which is the opposite side through an intermediate diode 6-2 adjacent to the anode parallel wiring 9A-2, the change-over switch 3 is arranged.

Hereinafter similarly, in moreover other anode parallel wiring 9A-3, the change-over switch 3 is arranged, in a cathode parallel wiring 9K-3 of the opposite side, the diode for parallel 10 is arranged et cetera, the above cases <1>, <2> may be mixed in every set of the anode parallel wiring 9A and the cathode parallel wiring 9K.

The plurality of the capacitors 2, which constitutes the earlier mentioned series wiring 5, the parallel wirings 9A, 9K, may switch to the series electric current state J1 by the change-over switches 3 described later at the time of charging (Figure 3(a)), may switch to the parallel electric current state J2 by the change-over switches 3 described later before discharging (Figure 3(b)), may start discharging of the output electric current Y by the discharge switch 4 after switching to the parallel electric current state J2.

In the case of charging and discharging in such order, after charging in series the plurality of the capacitors 2 in a predetermined voltage, it becomes to discharge in parallel electric current in a voltage lower than the predetermined voltage from the plurality of the capacitors 2, it becomes to discharge the output electric current Y which steps down the voltage from high voltage to low voltage according to the input electric current X's pathing through the charging and discharging circuit 1.

On the other hand, the earlier mentioned plurality of the capacitor 2 may switch to the parallel electric current state J2 by the change-over switches 3 described later at the time of charging, may switch to the series electric current state J1 by the change-over switches 3 before discharging, may start discharging of the output electric current Y by the discharge switch 4 after switching to the series electric current state J1.

In the case of charging and discharging in such order, after charging in parallel the plurality of the capacitors 2 in a predetermined voltage, it becomes to discharge in series electric current in a voltage higher than the predetermined voltage from the plurality of the capacitors 2, it becomes to discharge the output electric current Y which steps up the voltage from low voltage to high voltage according to the input electric current X's pathing through the charging and discharging circuit 1.

Below, we mainly describe the case that the plurality the capacitors 2 switches to the series electric current state J1 at the time of charging, switches to the parallel electric current state J2 at the time of discharging (it becomes from high voltage to low voltage).

### <Change-over switch 3>

As shown in Figures 1 to 3, the change-over switch 3 is a switch which is switchable to the above-mentioned series electric current state J1 and the parallel electric current state J2.

If the change-over switch 3 is switchable to the states J1, J2, the change-over switch 3 may be any constitution, for example, the change-over switch 3 may be a transistor member which is a MOSFET and so on that opens and closes the parallel wirings 9A, 9K (at the time of switching ON, the parallel wirings 9A, 9K are electrically conducted with)/at the time of switching OFF, the parallel wirings 9A, 9K make non-conductive), and may be an open-close switch which opens and closes the parallel wirings 9A, 9K by manual et cetera.

Below, we mainly describe that the change-over switch 3 is a MOSFET.

The change-over switch (a switching MOSFET) 3 is not limited about the constitution in particular, for example, may be a N-channel MOSFET, a P-channel MOSFET et cetera, may be arranged in the anode parallel wirings 9A, and/or, the cathode parallel wirings 9K.

In the case that the switching MOSFET 3 is arranged in the anode parallel wirings 9A, for example, the gate (G) of the switching MOSFET 3 may be connected to a switching output terminal 15 for a switching signal K1 from a timer part 11 described later, the drain (D) of the switching MOSFET 3 may be connected to the above-mentioned anode-capacitor interval 7A, the source (S) of the switching MOSFET 3 may be connected to the cathode end outside electrode 8K of the above-mentioned cathode end capacitor 2K.

On the other hand, in the case that the switching MOSFET 3 is arranged in the cathode parallel wiring 9K, for example, though it is same to the point that the gate (G) of the switching MOSFET 3 may be connected to a switching output terminal 15 for a switching signal K1 from a timer part 11 described later, the drain (D) of the switching MOSFET 3 may be connected to the above-mentioned the cathode-capacitor interval 7K, the source (S) of the switching MOSFET 3 may be connected to the anode end outside electrode 8A of the above-mentioned anode end capacitor 2A.

In the case that the plurality of the change-over switches 3 are arranged in the anode parallel wirings 9A, and/or, the cathode parallel wirings 9K, all the change-over switches 3 may be constituted to perform switching at the same time (the gate (G) of all the change-over switches 3 may be constituted to connect to same switching output terminal 15 for the switching signal K1 from the timer part 11, and so on), there may be time difference from switching of the states J1, J2 by each the change-over switch 3.

### <Series electric current state J1, Parallel electric current state J2 and so on>

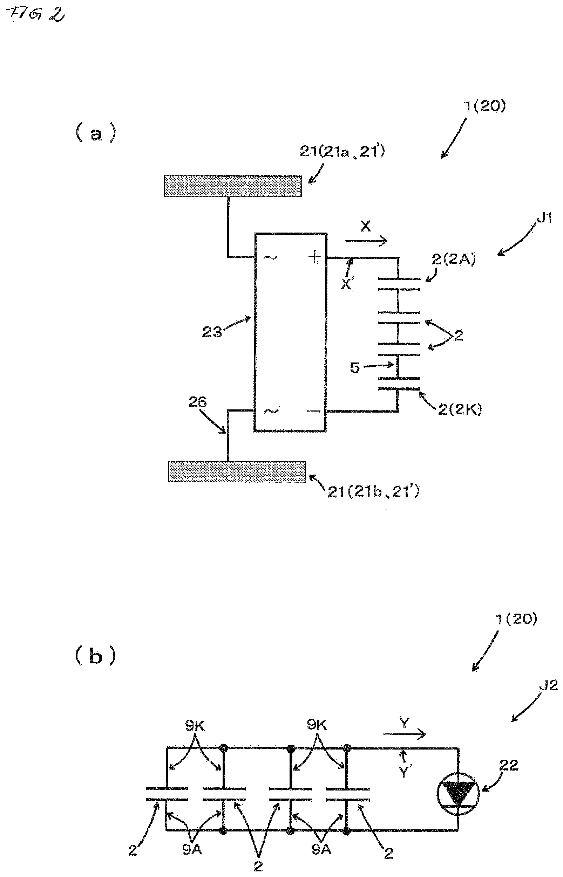

As shown in Figures 1 to 4 (in particular, Figure2), the series electric current state J1 is a state which electric current can flow to the plurality of the capacitors 2 in series, the parallel electric current state J2 is a state which electric current can be made to flow to the plurality of the capacitors 2 in parallel.

The series electric current state J1 and the parallel electric current state J2 are switched from the series electric current state J1 to the parallel electric current state J2, in the opposite way, from the parallel electric current state J2 to the series electric current state J1 by the above-mentioned change-over switches 3.

We describe these electric current states J1, J2 in detail, at the time that the change-over switches 3 in the parallel wirings 9A, 9K are switching OFF (the parallel wirings 9A, 9K are not electrically conducted with), the electric current can certainly be made to flow to the plurality of the capacitors 2 only in series, because each capacitor 2 is connected by only the series wiring 5.

Accordingly, it can be said that the series electric current state J1 is the time of the change-over switches 3 are switching OFF.

On the other hand, at the time that the change-over switches are switching ON (the parallel wirings 9A, 9K are electrically conducted with), the electric current can be made to flow the plurality of the capacitors 2 not only in series, but also in parallel, because each capacitor 2 is connected by not only the series wiring 5, but also by the parallel wirings 9A, 9K.

Consequently, when the change-over switches 3 are switching ON, the series electric current state J1 is at the same time of the parallel electric current state J2, it also can be said that such state is a series and parallel electric current state J3.

Furthermore, it also can be said that the change-over switch 3 is switchable to the parallel electric current state J2 which the electric current can be made to flow to the plurality of the capacitors 2 in parallel, because the series and parallel electric current state J3 is the state that the electric current is made to flow to the plurality of the capacitors 2 only in parallel by switching ON the discharge switch 4 described later.

Below, we describe the discharge switch 4 which influences the electric current made to flow actually to the capacitors 2 like this.

### <Discharge switch 4>

As shown in Figures 1 to 4,the discharge switch 4 is a switch which starts discharging of the output electric current Y from the plurality of the capacitors 2.

It is preferable that the discharge switch 4 starts discharging from the plurality of the capacitors 2, and is arranged apart from the change-over switches 3 (at a different position from the change-over switches 3), for example, the discharge switch 4 also may be a transistor member which is a MOSFET and so on that opens and closes a wiring (output wiring) Y' discharging the output electric current Y (at the time of switching ON, the output wiring Y' is electrically conducted with)/at the time of switching OFF, the output wiring Y' makes non-conductive), and may be an open-close switch which opens and closes the output wiring Y' by manual et cetera.

Below, we mainly describe the discharge switch 4 is a MOSFET which is arranged in the output wiring Y'.

We describe the arrangement position of the discharge switch (a discharge MOSFET) 4 in detail, for example, it may be a case (a case of low side switch) that the discharge MOSFET 4 is arranged at lower electric potential side (for example, GND side and so on) than electric potential of a load (a light-emitting part 22 as mentioned below and so on) which is supplied the output electric current Y in the output wiring Y' discharging the output electric current Y, and the discharge MOSFET 4 switches ON/OFF at the lower electric potential side. At this time, the discharge switch 4 may be an N-channel MOSFET et cetera.

The gate (G) of the discharge switch 4 which is the N-channel MOSFET et cetera, for example, may be connected to a discharge output terminal 16 for a discharge signal K2 of the timer part 11 described later through a predetermined element, the drain (D) of the discharge switch 4 may be connected to the load (the light-emitting part 22) et cetera, the source (S) of the discharge switch 4 may be connected to GND of the charging and discharging circuit 1 (the output wiring Y' of the low electric potential side of the charging and discharging circuit 1).

Furthermore, this GND is connected to the cathode end outside electrode 8K of the above-mentioned cathode end capacitor 2K.

Besides, as regards the arrangement position of the discharge switch 4, for example, it may be a case (a case of high side switch) that the discharge MOSFET 4 is arranged at higher electric potential side than electric potential of a load (the light-emitting part 22 and so on) in the output wiring Y', and the discharge MOSFET 4 switches ON/OFF at the higher electric potential side. At this time, the discharge switch 4 may be a P-channel MOSFET et cetera.

Though it is same to the case of low side switch that the gate (G) of the discharge switch 4 which is the P-channel MOSFET et cetera, for example, may be connected to a discharge output terminal 16 for a discharge signal K2 of the timer part 11 described later through a predetermined element, the drain (D) of the discharge switch 4 may be connected to the load (the light-emitting part 22) et cetera, the source (S) of the discharge switch 4 may be connected to the anode end outside electrode 8A of the above-mentioned anode end capacitor 2A.

Furthermore, this anode end outside electrode 8A is the output wiring Y' of high electric potential side in the charging and discharging circuit 1.

### <Timer part 11, Power supply terminal 12, Timer power supply wiring 13, Diode for power supply 14 and so on>

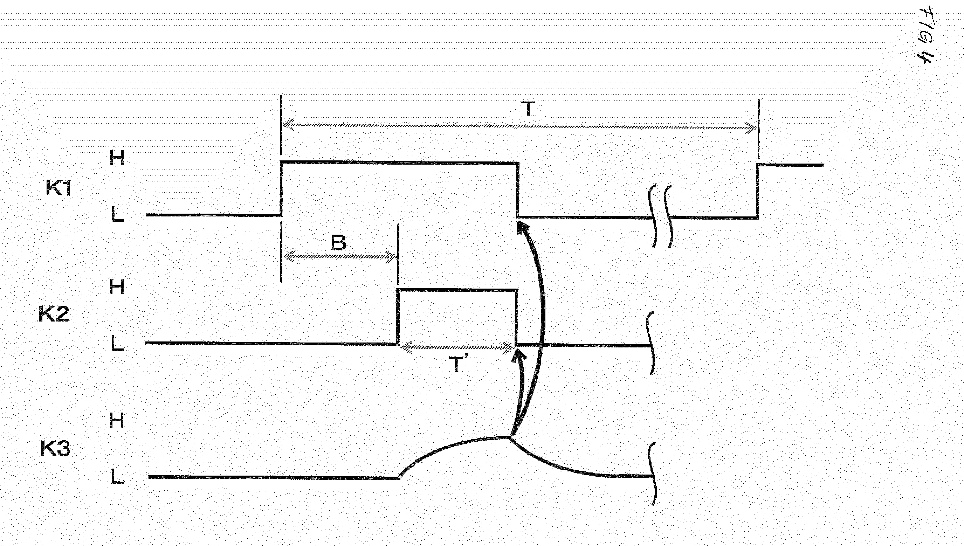

As shown in Figures 1, 4, the timer part 11 periodically performs switching by the above-mentioned change-over switch 3 and discharge starting by discharge switch 4.

If the timer part 11 periodically performs switching by the change-over switch 3 and discharge starting by the discharge switch 4, the timer part 11 may be any constitution, for example, the timer part 11 may comprise a power supply terminal (a VDD terminal in Figure 1) 12,a switching output terminal (a WAKE terminal in Figure 1) 15 of the above-mentioned switching signal K1, a discharge output terminal (a TCAL terminal in Figure 1) 16 of the discharge signal K2, then, a stop input terminal (a DONE terminal in Figure 1) 17 inputting a stop signal K3 which stops discharging to the load (the light-emitting part 22 described later and so on), and a cycle setting terminal (a DO,D1,D2 terminal in Figure 1) 18 setting a period (a discharge period) T of switching by the above-mentioned change-over switch 3 and discharge starting by discharge switch 4 and so on.

The timer power supply wiring 13 is a wiring connecting the power supply terminal 12 of the above-mentioned timer part 11 to the diode-capacitor interval 7D between the cathode end capacitor 2K in the above-mentioned series wiring 5 and the intermediate diode 6 adjacent to the cathode end capacitor 2K.

In this timer power supply wiring 13, a diode for power supply 14 is arranged in a forward direction form the diode-capacitor interval 7D to the power supply terminal 12.

### <Discharge period T>

As shown in Figure 1, it can set a discharge period T, which makes output of the switching signal K1 and the discharge signal K2 (in more detail, change of "L"/"H" in the switching signal K1 and the discharge signal K2), to a predetermined value (1 second, 2 seconds, 4 seconds, 8 seconds, 10 seconds, 16 seconds, 32 seconds, 64 seconds and so on), according to inputting electric potentials of "0 (L: low)"of "1 (H: high)"to each the above-mentioned period setting terminal 18.

For example, it is preferable that a constitution which can set the discharge period T to 1 second by inputting "0"of electric potential to a D2 terminal in a period setting terminals 18, "0"of electric potential to a D1 terminal in a period setting terminals 18, "0"of electric potential to a D0 terminal in a period setting terminals 18, and can set the discharge period T to 2 seconds by inputting "0"of electric potential to the D2 terminal, "0"of electric potential to the D1 terminal, "1" of electric potential to the D0 terminal.

Input of the electric potential of such"0", "1" to each period setting terminal 18 is constituted that, for example, in order to become the D0 terminal to "0"of electric potential, the D0 terminal is connected to the above-mentioned timer power supply wiring 13 through a resistor of N mega-ohms (for example, sufficient large resistor including several mega-ohms and so on), and the D0 terminal is connected to the above-mentioned GND through a resistor of 0 ohm (or, a wiring without resistor).

Similarly, it is constituted that, in order to become the D1 terminal to"0"of electric potential, the D1 terminal is connected to the timer power supply wiring 13 through a resistor of N mega-ohms (for example, sufficient large resistor including several mega-ohms and so on), and the D1 terminal is connected to the GND through a resistor of 0 ohm (or, a wiring without resistor), in order to become the D2 terminal to"0"of electric potential, the D2 terminal is connected to the GND by a wiring without resistor.

### <Timing chart of Switching signal K1, Discharge signal K2, Stop signal K3>

Figure 4 shows a timing chart of each signal in the timer part 11.

The switching signal K1 of these signals is output from the above-mentioned switching output terminal 15 and is input to the change-over switches 3 (Q1 to Q3 in Figure 1).

At first, the switching signal K1 is in "L (or,0)"of electric potential as a state (the series electric current state J1 in the plurality of the capacitors 2) that the change-over switches 3 are switching OFF, and the switching signal K1 rises to "H (or,1)" of electric potential every the above-mentioned discharge period T as a state that the change-over switches 3 are switching ON (the parallel electric current state J2 (or, the series and parallel electric current state J3) in the plurality of the capacitors 2).

The discharge signal K2 is output from the above-mentioned discharge output terminal 16 and is input to the terminal (gate (G)) of the discharge switch (the discharge MOSFET et cetera) 4 and so on through a predetermined element.

At first, the discharge signal K2 also is in "L (or,0)"of electric potential as a state that the discharge switch 4 is switching OFF, and the discharge signal K2 rises to "H (or,1)" of electric potential after a predetermined delay time B (for example, about 8 milli-seconds) from the rising of from "L" to "H" of the above-mentioned switching signal K1 as a state that the discharge switch 4 is switching ON, it may make the output electric current Y from the plurality of the capacitors 2 discharged to the load (the light-emitting part 22 and so on) by the output wiring Y' in the charging and discharging circuit 1.

In this case, the timer part 11 switches to the parallel electric current state J2 by the change-over switches 3 before discharging from the plurality of the capacitors 2, and starts discharging of the output electric current Y after switching to the parallel electric current state J2 by the discharge switch 4.

From this, it becomes to discharge as the low electric potential certainly, after completing to switch from series to parallel after charging, if the alternating electric path R' is high voltage (for example, 6600V, 22000V and so on), it restrains to impose an overload to the light-emitting part 22, and it prevents to discharge halfway the output electric current Y to the load (the light-emitting part 22 and so on).

Furthermore, in a case that the charging and discharging circuit 1 don't comprise a switch to not flow the input electric current X to the capacitors 2 (a charge propriety switch et cetera), it also can be said that the input electric current X is made to flow in the capacitors 2 in accordance with voltage of each capacitor 2 at the time of discharging from the capacitors 2 too.

The stop signal K3 is a signal that the discharge signal K2 output from the above-mentioned discharge output terminal 16 passes a RC circuit 19 having a predetermined time constant tau et cetera, the stop signal K3 inputs the stop input terminal 17.

This RC circuit 19 is constituted of resistors connected in series (R10 and R11 in Figure 1) and a capacitor (C6 in Figure 1), the stop signal K3 (it also can be said integral waveform of the discharge signal K2) inputs the stop input terminal 17, according to connecting the stop input terminal 17 to the resistor and the capacitor through a predetermined resistor (R12 in Figure 1).

At first, the stop signal K3 being input also is in "L (or,0)"of electric potential, after the discharge signal K2 is input through the RC circuit 19, the electric potential ascends in accordance with the time constant tau of the RC circuit 19, if the timer part 11 determines that the electric potential of the stop signal K3 becomes about half (1/2) of electric potential (a power supply electric potential, a power supply voltage) of the power supply terminal 12 of the timer part 11 (the electric potential of the stop signal K3 becomes "H"), the timer part 11 makes the electric potential of the above switching signal K1 and the discharge signal K2 "L (or,0)".

The change of the electric potential can be adjusted in accordance with the time constant tau of the above-mentioned RC circuit 19, the time constant tau can be calculated to a predetermined value (for example, 1.22 mega-ohms * 2.2 nano-farads= 2.684 micro-seconds) by a product of a resistor value of the RC circuit 19 (for example, 1.0 mega-ohms + 220 kilo-ohms = 1.22 mega-ohms and so on) and a static capacitance (for example, 1 nano-farads and so on).

Furthermore, time that the electric potential of the stop signal K3 becomes to about half of the power supply voltage, that is, a discharge time T' to the load (time of discharging, as a specific example, a light-emitting time that the light-emitting part 22 being discharged emits light) becomes that a value, which is multiplied the above time constant tau by ln2 (= loge2,e is base of natural logarithm), is an approximate value (for example, 2.684 micro-seconds * loge2 = 2.684 micro-seconds * 0.693147... = 1.860... , approximately equal is 1.86 milli-seconds, it also can be said that the approximate value is a half-life period of "H" electric potential by multiplying ln2.

As regards the discharge time (the light-emitting time) T', it also can be said that the power supply voltage of the timer part 11 descends while discharging the output electric current Y from the capacitors 2 (in particular, the cathode end capacitor 2K) to the load (the light-emitting part 22 and so on), there is a case that the discharge time T' is shorter than the approximate value which is the time constant tau * ln2 (for example, 1.64 milli-seconds and so on).

Accordingly, it becomes possible to adjust the time constant tau as intended (that is, an intended discharge time T'), according to changing the resistor value and the static capacitance in the RC circuit 19.

After such discharge time T' has passed, it is determined that the stop signal K3 is "H", the change-over switches 3 are switching OFF, the plurality of the capacitors 2 switches to the series electric current state J1, according to the switching signal K1 and the discharge signal K2's becoming "L". At the same time of this, the discharge switch 4 also is switching OFF, it makes to stop discharging of the output electric current Y from the plurality of the capacitors 2.

The charging and discharging circuit 1 starts to charge the input electric current X to the plurality of the capacitors 2 which electric current is made to flow in series again, according to switching to the series electric current state J1 and stopping discharge.

The earlier mentioned like, the timer part 11 repeats changing of the switching signal K1, the discharge signal K2 and the stop signal K3, and discharging by a predetermined discharge time T' every the above-mentioned discharge period T.

Besides, the timer part 11 may comprise a GND terminal (a GND terminal in Figure 1), a power supply judging terminal (a PGOOD terminal in Figure 1) which judges whether the power supply voltage applies for the timer part 11 can be driven normally, a reset terminal (a RST terminal in Figure 1) and so on, too.

The GND terminal of these terminals is connected to GND (output wiring Y' of the low electric potential side in the charging and discharging circuit 1, the cathode end outside electrode 8K of the cathode end capacitor 2K).

The power supply judging terminal is connected to between the power supply terminal 12 in the above-mentioned timer power supply wiring 13 and the diode for power supply 14.

The reset terminal may be not connected to any, in particular.

Furthermore, a capacitor (C5 in Figure 1) is connected to between the power supply terminal 12 of the timer part 11 and the above-mentioned GND (the cathode end outside electrode 8K), the capacitor performs noise removal et cetera.

And, a resistor (a gate resistor, R2 in Figure 1) may be arranged between the switching output terminal 15 of the timer part 11 and a gate (G) of a change-over switch 3 (a switching MOSFET et cetera).

Moreover, a resistor (a gate resistor, R9 in Figure 1) may be arranged between the discharge output terminal 16 of the timer part 11 and the gate (G) of the discharge switch 4(the discharge MOSFET et cetera).

<The charging and discharging circuit 1 of the 2nd embodiment>

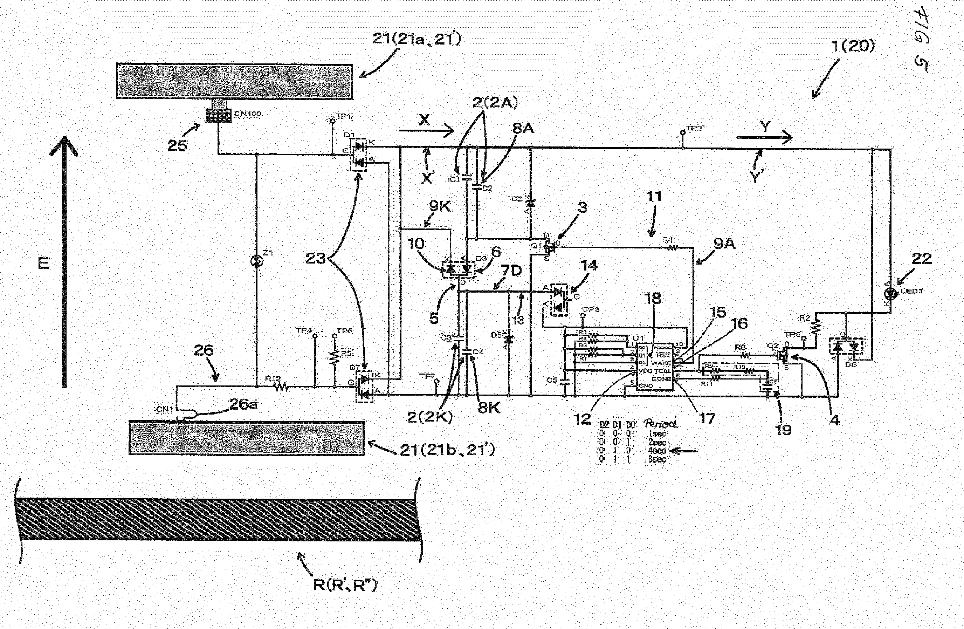

Figure 5 shows the charging and discharging circuit 1 of the 2nd embodiment of the present invention.

A most different point between the 1st embodiment and the 2nd embodiment is a point that the number of the capacitors 2 is two.

And, not only the number, each capacitor 2 of the 2nd embodiment is what some capacitor members are gathered, more specifically, the capacitors 2 is a combination of what a plurality of capacitor members is connected in parallel (C1 and C2, C3 and C4 et cetera in Figure 5).

Consequently, static capacitance as one capacitor 2 is the double of static capacitance of each capacitor member constituting the one capacitor 2 (for example, sum total of two capacitor members, that each capacitor member is 2.2 micro-farads in nominal value, is 4.4 micro-farads and so on).

Furthermore, the number of the capacitor members connected in parallel may be not two, be three or more.

And, a different point between the 1st embodiment and the 2nd embodiment is a point that the number of the intermediate diodes 6 in the series wiring 5 is one, and a point that the number of the anode parallel wirings 9A and the cathode parallel wirings 9K is each one too.

Besides, the timer part 11 of the 2nd embodiment, unlike thelst embodiment, it sets the discharge period T to 4 seconds by inputting "0"of electric potential to the D2 terminal, "1" of electric potential to the D1 terminal, "0"of electric potential to the D0 terminal in the period setting terminals 18.

Input of the electric potential of such"0", "1" to each period setting terminal 18 is constituted that, for example, in order to become the D0 terminal to "0"of electric potential, the D0 terminal is connected to the above-mentioned timer power supply wiring 13 through a resistor of N mega-ohms (for example, sufficient large resistor including several mega-ohms and so on), and the D0 terminal is connected to the above-mentioned GND through a registor of 0 ohm (or, a wiring without resistor).

And, it may be constituted that, in order to become the D1 terminal to "1" of electric potential, the D1 terminal is connected to the timer power supply wiring 13 through a resistor of 0 ohm (or, a wiring without resistor), and the D1 terminal is connected to the GND through a resistor of N mega-ohms (for example, sufficient large resistor including several mega-ohms and so on), in order to become the D2 terminal to"0"of electric potential, the D2 terminal is connected to the GND by a wiring without resistor.

Other constitution, operation, effect and use mode of the charging and discharging circuit 1 of the 2nd embodiment are same as the 1st embodiment.

### <The electroscope 20 of the 1st embodiment>

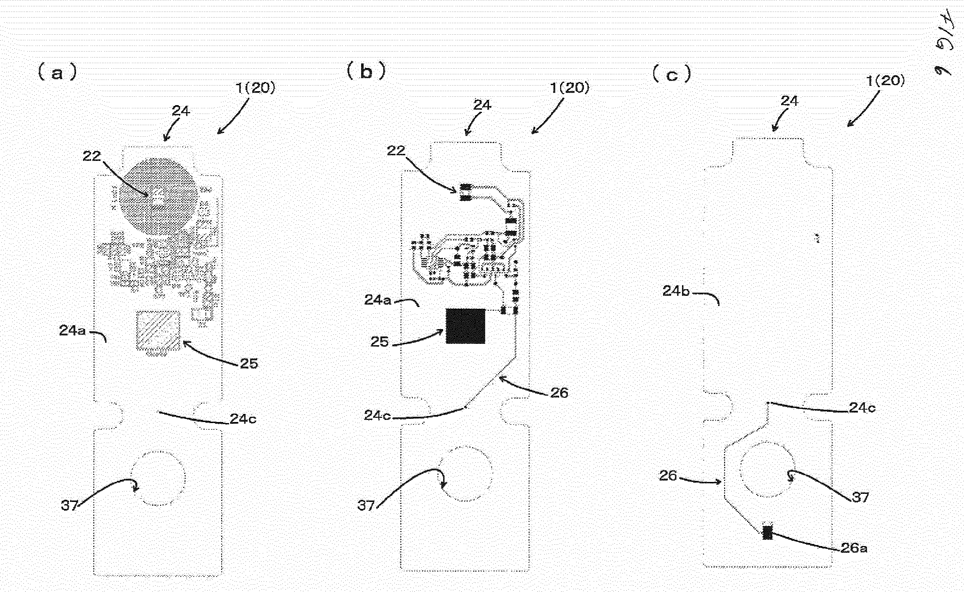

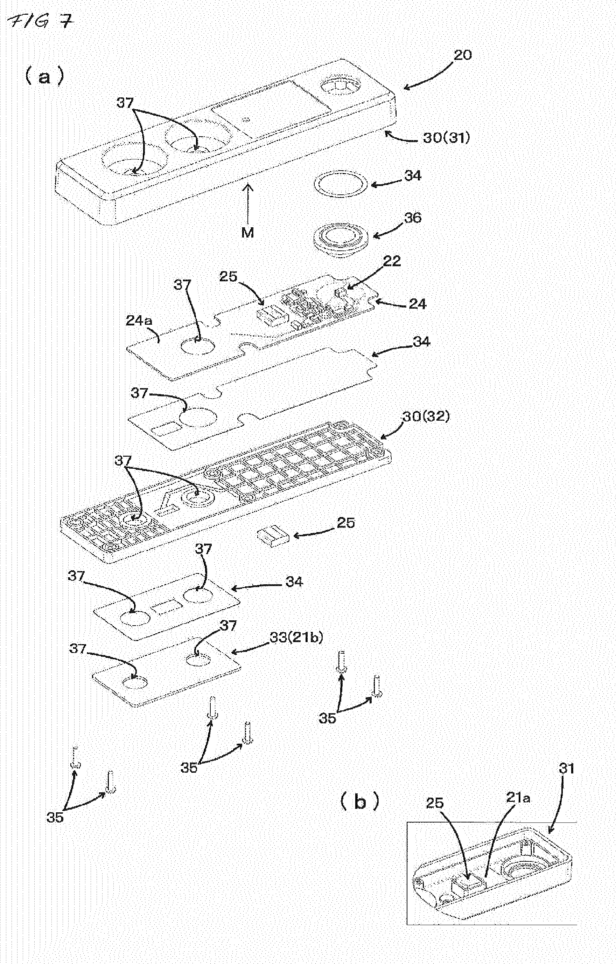

As shown in Figures 1 to 8, the electroscope 20 of the 1st embodiment comprises the charging and discharging circuit 1 of the 1st, 2nd embodiments et cetera, the electroscope 20 inspects energization of an electric path R using the output electric current Y discharged from the charging and discharging circuit 1.

The electroscope 20 comprises a pair of gate electrodes 21 connected to the anode end outside electrode 8A and the cathode end outside electrode 8K in the charging and discharging circuit 1, and a light-emitting part 22 which flickers by the output electric current Y periodically discharged from the plurality of the capacitors 2 in the charging and discharging circuit 1.

Besides, like described later, if the electric path R is an alternating electric path R', the electroscope 20 may comprise a rectifier 23 which converts alternating electric current to direct electric current.

And, in the first place, we describe the electric path R inspected the energization by such electroscope 20 in detail.

### <Electric path R (Alternating electric path R'), Electric field E and so on>

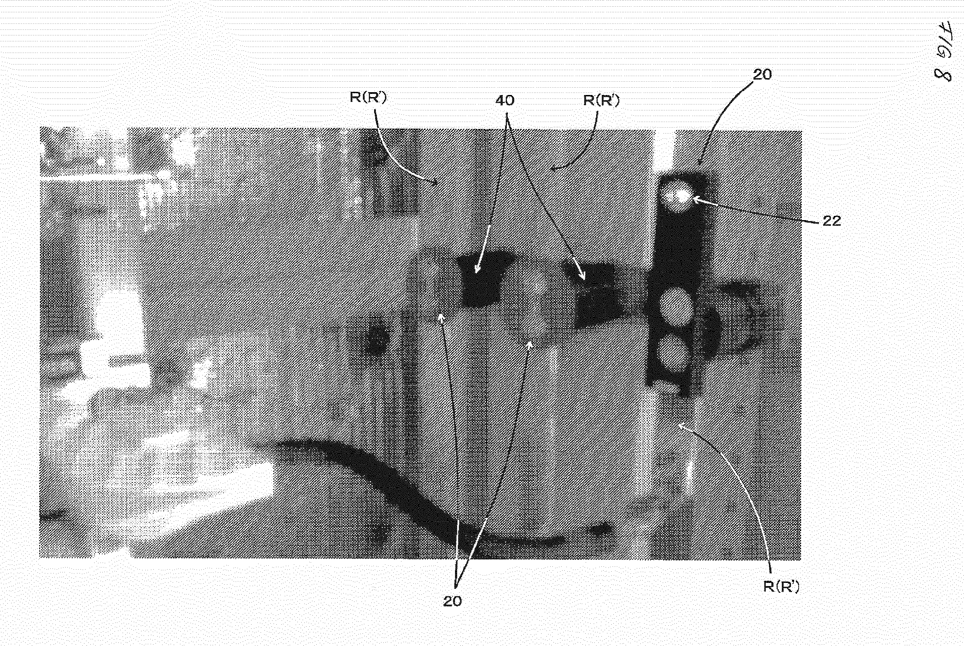

As shown in Figures 1, 8, the electric path R is a path of electric current or electric circuit, the electric path R is inspected whether it is electrically conducted with, whether electric current is made to flow (whether it is energized) by the electroscope 20, the electric path R is an electric conductor of a copper, an aluminum, a silver, a gold, a nichrome et cetera, the electric path R includes a cable, a typical electric wire and so on covered the electric conductor by insulating material.

Electric current being made to flow in the electric path R may be any of alternating electric current, direct electric current, the electric path flowing alternating electric current is an alternating electric path R', the electric path flowing direct electric path is an direct electric path R".

If the electric path R flows electric current, the electric path R may be any constitution, for example, the alternating electric path R' may be three-phase cables (a piece of two pieces of those cables), or bus bar(refer to Figures 1, 5, 8), which have a predetermined voltage (for example, if high voltage, 6600V, 22000V and so on, if low voltage, 100V to 200V and so on) in electric power distributors of solar power generation plants (solar power generating stations).

Furthermore, as shown in Figure 8, the inside of the electric power distributors is dim, if through the cover moreover, it is difficult to confirm the position of the alternating electric path R'. However, it can show state which is energized for a user easily by the light-emitting part 22 of the electroscope 20.

As other example of the alternating electric path R', the alternating electric path R' may be an electrical outlet, a breaker provided in a house, a building as commercial power supply, including a power transmission facility and so on.

On the other hand, as example of the direct electric path R", the direct electric path R" may be many solar battery panels in the solar power generation plant, many solar battery strings connected a plurality of the solar battery panels in series, direct electric current cables in connection boxes collecting the plurality pieces of the solar battery strings.

As other example of the direct electric path R", the direct electric path R" may be electric appliances flowing the direct electric current, including a computer of desktop type, notebook type and so on, office equipment, every kind terminal device and so on.

Below, we describe the electric path R is the alternating electric path R' (in particular, the three-phase cable of 6600V, 22000V).

### <One pair of the gate electrodes 21 (the gate capacitors 21')>

As shown in Figures 1, 5 to 7, the one pair of the gate electrodes 21 is a pair of electrodes connected to the anode end outside electrode 8A and the cathode end outside electrode 8K in the charging and discharging circuit 1, the one pair of the gate electrodes 21 constitutes the gate capacitors 21' of the gate electrodes 21.

When the one pair of the gate electrodes 21 is positioned in the electric field E generated by the energization of the above-mentioned electric path R (the alternating electric path R' et cetera), the electric potential difference is generated between the one pair of the gate electrodes 21.

If between the one pair of the gate electrodes 21, the electric potential difference is generated in when the one pair of the gate electrodes 21 is positioned in the electric field E generated by the energization of the alternating electric path R' et cetera, the one pair of the gate electrodes 21 may be provided in any position in the electroscope 20, for example, each gate electrode 21 may be provided in a cover (a lid, a front face) 31 side of a casing 30 built in a circuit board 24 of the charging and discharging circuit 1, and a back face side of a chassis 32 supporting the circuit board 24 by the casing 30.

The gate electrode 21 (21a) of the cover 31 side may be a cover side metal (an iron, a copper, an aluminum, a silver, a gold, a nichrome et cetera) plate (not shown) mounted to the inside of the cover 31, the gate electrode 21 (21a) may be what is painted with conductive paint including a copper, a nickel et cetera of conductive material on the inside of the cover 31 et cetera.

The gate electrode 21a of the cover 31 side may connect to the anode end outside electrode 8A or the cathode end outside electrode 8K in the charging and discharging circuit 1 through a gate contactor (for example, a gasket and so on which winds conductive cloth to polyurethane foam).

On the other hand, the gate electrode 21 (21b) of the back face side of the chassis 32 may be a back face side metal (an iron, a copper, an aluminum, a silver, a gold, a nichrome et cetera) plate 33 provided on the back face side of the chassis 32, in this side, the gate electrode 21 (21b) also may be what is painted with conductive paint on the inside of the cover 31 et cetera.

The gate electrode 21b of the back face side of the chassis 32 may connect to the end outside electrodes 8K, 8A not connected the gate electrode 21a of the cover 31 side of the cathode parallel wiring 9K and the anode end outside electrode 8A in the charging and discharging circuit 1, through a gate electrode wiring 26.

This gate electrode wiring 26 may be wired from a components face (front face) 24a side of the circuit board 24 in the charging and discharging circuit 1, through a penetrating hole 24c, to a solder face (reverse face) 24b side, the gate electrode wiring 26 may be connected to the gate electrode 21b (metal plate 33 and so on) of the back face side of the chassis 32 through a wiring terminal 26a.

Furthermore, each the capacitor 2, each the switch 3, 4, each the wiring 5, 10, 13, each diode 6, 10, 14, the timer part 11, the RC circuit 19, and other resistor members, diode members, lightning surge protection elements described later in the charging and discharging circuit 1 are arranged on the components face (front face) 24a side of the circuit board 24.

And, the circuit board 24 and the chassis 32, the chassis 32 and the back face side metal plate 33 may be stuck by double sided tape 34, the chassis 32 and the cover 31 may be fixed with a predetermined number of screws 35.

The distance between the gate electrode 21 of the cover 31side and the gate electrode 21 of the back face side of the chassis 32 is not limited in particular, the distance may be more than a predetermined value (for example, 10 milli-meters and so on).

Though there are the charging and discharging circuit 1 and the circuit board 24 et cetera built in the casing 30 between the one pair of the gate electrodes 21, there may be other cavity (air).

Static capacitance between the one pair of the gate electrodes 21 (the gate capacitors 21') is not limited in particular, for example, may be more than 0.005 pico-farads and less than 50000.000 pico-farads, preferably may be more than 0.01 pico-farads and less than 10000.00 micro-farads, more preferably may be more than 0.1 pico-farads and less than 1000.00 pico-farads (0.5 pico-farads, 4 pico-farads, 20 pico-farads, 100 pico-farads, 200 pico-farads, 250 pico-farads and so on).

### <Light-emitting part 22>

As shown in Figures 1, 2, 4, 5, 7, 8, the light-emitting part 22 is what shows by light a state that the electric path R (the alternating electric path R' et cetera) is energizing (the light-emitting part 22 is shown by LED1 in Figures 1, 5).

The light-emitting part 22 may show the state that the alternating electric path R' et cetera is energizing by flickering light and so on, the light-emitting part 22 may be any constitution.

The light-emitting part 22, specifically, may be a light-emitting diode (LED), an organic EL (an organic electro-luminescence), a neon lamp and the like, and if what emits light, the light-emitting part 22 may be a discharge lighting, like a halogen lamp, an incandescent light bulb, a fluorescent lamp (a fluorescent lighting), a mercury lamp (a mercury lighting) et cetera.

Below, we mainly describe that the light-emitting part 22 is a light-emitting diode.

The light-emitting part 22 may be a constitution emitting light (lighting on) in a predetermined discharge period (it also can be said that the light-emitting period) T by the above-mentioned charging and discharging circuit 1, a duty ratio D of the discharge time (the light-emitting time) T' against the light-emitting period T (that is, the duty ratio D = (the light-emitting time T') / (the light-emitting period T)) may be more than 0.000001 and less than 0.500000.

Furthermore, when the light-emitting part 22 is built in the casing 30 of the electroscope 20, a lens 36 may be covered on the light-emitting part 22, this lens 36 and the cover 31 of the casing 30 may be stuck mutually by double sided tape 34.

### <Rectifier 23>

As shown in Figures 1,2, 5, the rectifier 23 is what converts the alternating electric current from the alternating electric path R' to the direct electric current (the rectifier 23 are shown by D1 and D10 in Figure 1, the rectifier 23 are shown by D1 and D7 in Figure 5).

If the rectifier 23 can convert the alternating electric current from the alternating electric path R' to the direct electric current, the rectifier 23 may be any constitution, for example, the rectifier 23 may use two of what is combined two diode members to one element.

### <Usage of the electroscope 20 of the 1st embodiment >

At the time of usage of the 1st embodiment of the electroscope 20, the electroscope 20 may be mounted to the electric path R, in a state that brings close and approaches the back face side of the casing 30 to the electric path R, against mounting holes 37 penetrating one end part (a lower part) of the casing 30, by fixing means like a bolt, a washer, a nut, a metal fitting et cetera.

And, a groove (not shown) is formed in the one end part of the casing 30, the electroscope 20 may be mounted to the electric path R using a hose band, cable ties et cetera along the groove.

### <Other member of the electroscope 20 of the 1st embodiment>

As shown in Figures 1, 5, the electroscope 20 of the 1st embodiment may comprise the above-mentioned charging and discharging circuit 1, the plurality of the capacitors (the charge capacitors) 2, the change-over switches 3, the discharge switch 4, the series wiring 5, the intermediate diodes 6, the parallel wirings 9A, 9K, the diodes for parallel 10, the timer part 11, the timer power supply wiring 13, the diode for power supply 14, the one pair of the gate electrodes 21 (the gate capacitors 21'), the light-emitting part 22, the rectifier 23 et cetera, in addition to a resistor member, a diode member, a lightning surge protection element and so on, below, examples are described.

The resistor members (the resistor members are shown by R3, R6, R13 in Figure 1, the resistor members are shown by R2, R5, R12 in Figure 5) may comprise each role, for example, it also can be said that the R3 in Figure 1 (the R2 in Figure 5) is an electric current limiting resistor of the light-emitting part 22 (LED1), it also can be said that the R6 in Figure 1 (the R5 in Figure 5) is an electric current limiting resistor for monitoring a test point (TP5 in Figures 1, 5). Furthermore, TPs 1 to 7 in Figures 1, 5 mean test points 1 to 7.

It also can be said that D9 in Figure 1 of the diode member (D6 in Figure 5) is what protects connect in reverse of the light-emitting part 22, and prevents counter electromotive force when the light-emitting part 22 is switching OFF.

R13 and Z1 in Figure 1 (R12 and Z1 in Figure 5) are elements for lightning protection, in the first place, it can be said that the resistor member of the R13 prevents high voltage to be applied instantly to a circuit after the rectifier 23, it can be said that when voltage between the terminals in the internal resistor of the rectifier 23 increases, a lightning surge protection element of the Z1 prevents ascending of terminal voltage by electric current is made to flow to earth.

### <The Capacitor unit 101 of the 1st embodiment>

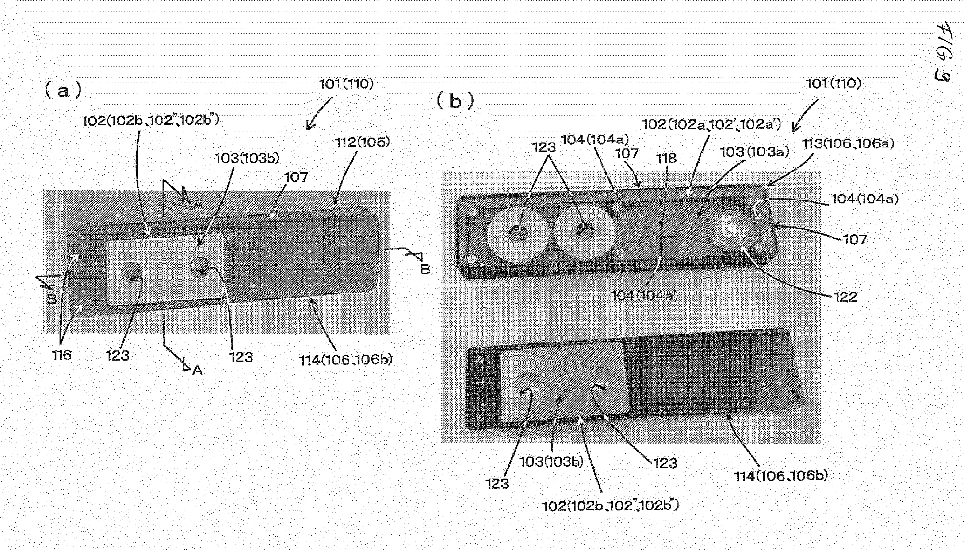

Figures 9 to 12, 15, 16 show the capacitor unit 101 of the 1st embodiment of the present invention.

This capacitor unit 101 comprises a pair of electrodes 102, the capacitor unit 101 comprises a casing 105 holding the one pair of the electrodes 102 too.

### <One pair of the electrodes 102>

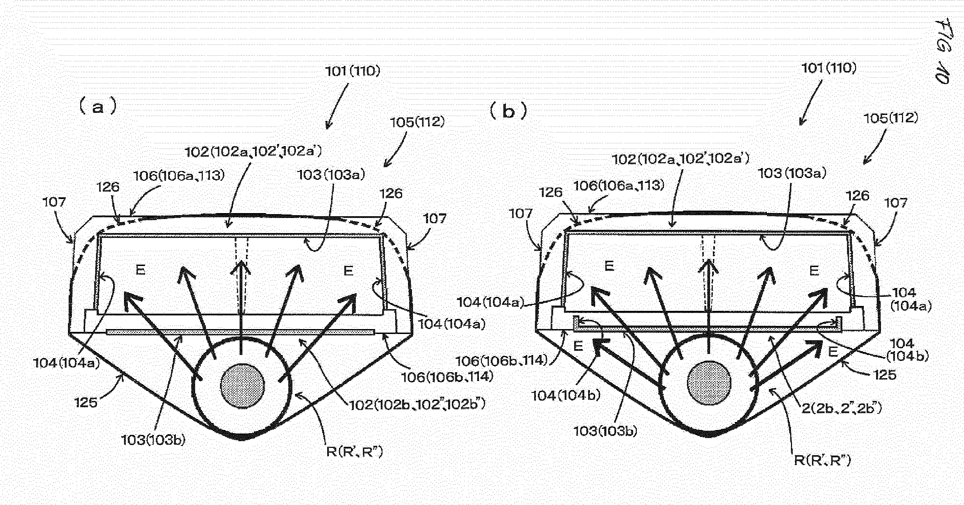

A shown in Figures 9 to 12, 15, 16 (in particular, Figure 10(a)), both the electrodes 102 (102a, 102b) of the one pair are electric conductors comprising almost parallel body parts 103 (103a, 103b) mutually.

In a case of the capacitor unit 101 of the 1st embodiment, only the one electrode 102a of the one pair of the electrodes 102a, 102b comprises a non-parallel part 104 (104a) which stands toward the another (the other) electrode 102b side on the end of the body part 103 (103a), and is not almost parallel to the another (the other) electrode 102b, in the non-parallel parts 104 stand on both end of the body part 103, it also can be said that the electrodes 102 is an approximate U-shape (an approximate C-shape) in a cross sectional view.

The distance between the one pair of the electrode 102 is not limited in particular, the distance may be more than a predetermined value (for example, 10 milli-meters and so on).

There are the charging and discharging circuit 131 and the circuit board 133 et cetera built in the casing 105 (the casing 112 of the electroscope 110) as mentioned below between the one pair of the electrodes 102, besides, a cavity (an air), a dielectric, that relative dielectric constant is greater than 1, may be hold between the one pair of the electrodes 102, the state between the electrodes may be the state that the relative dielectric constant is 1 (that is, the state that there is vacuum between the electrodes) and so on, the state between the electrodes may be any state.

The static capacitance of between the one pair of electrodes 102 is not limited in particular, for example, may be more than 0.005 pico-farads and less than 50000.000 pico-farads, preferably may be more than 0.01 pico-farads and less than 10000.00 micro-farads, more preferably may be more than 0.1 pico-farads and less than 1000.00 pico-farads (0.5 pico-farads, 4 pico-farads, 20 pico-farads, 100 pico-farads, 200 pico-farads, 250 pico-farads and so on).

Besides, the one pair of the electrodes 102 may be same material et cetera, in the opposite way, the electrodes 102 may be different material, we described these material later.

And, when the one pair of the electrodes 102 is positioned in a predetermined electric field E (an electric field E generated by the energization of the electric path R described later (the alternating electric path R' et cetera)), the electric potential difference is generated between the one pair of the electrodes 102.

### <Body part 103 of the electrodes 102>

As shown in Figure 10 (a) in particular, the body parts 103 (103a, 103b) are provided in both the electrodes 102 (102a, 102b) of the one pair (the body parts 103 is one part of the electrode 102), the body parts 103 (103a, 103b) are almost parallel portions mutually.

At this point, "almost parallel" means, for example, not only a state that flat electric conductors are almost parallel each other, besides, it also can be said that "almost parallel" means a state that though electric conductors are curved, waveform, bending zigzag each other in side view, like a modified example as mentioned below, at arbitrary spots placing opposite to (facing each other) or arbitrary spots bringing closest mutually in the one pair of the electric conductors, distances between the arbitrary spots are almost same.

If the one pair of the body parts 103a, 103b is almost parallel mutually, the shape of the body parts 103a, 103b are not limited in particular, for example, both of the body parts 103a, 103b may be an approximate plate-like shape body, an approximate rectangular parallelepiped body, the one of the body parts 103a, 103b may be an approximate plate-like shape body, the other of the body parts 103a, 103b may be an approximate rectangular parallelepiped body.

The plan-view shape of the one pair of the body parts 103a, 103b also may be any shape, for example, the plan-view shape of the body parts 103a, 103b may be an approximate rectangular shape, an approximate square shape, and an approximate circle shape, an approximate ellipse shape, a triangle, and a hexagon and so on.

Besides, the one pair of the body parts 103a, 103b may be same shape, same size, same thickness et cetera each other, in the opposite way, the body parts 103a, 103b may be different shape, different size, different thickness et cetera.

And, ruggedness may be slightly formed on each body part 103a, 103b, it is preferable that an upper face of a convex part and a bottom face of a concave part of the ruggedness in the one body part 103 may be almost parallel to the other body part 103.

Furthermore, if the side face of the ruggedness of each body part 103a, 103b (an outside face, an inside face, an end face and so on) is not almost parallel to the other body part 103, it also can be said that the ruggedness is the non-parallel part 104 described later even in a case that the ruggedness is not formed the end of the body part 103.

Below, we describe the non-parallel part 104.

### <Non-parallel part 104 of the electrode 102>

As shown in Figure 10 (a) in particular, the non-parallel part 104 (104a), in the 1st embodiment, are provided in only the one (the one of the electrode 102a) of the one pair of the electrodes 102a, 102b (the non-parallel part 104 is one part of the electrode 102a).

The non-parallel part 104a stands toward the other electrode 102b side on the end of the one of the body part 103a, and is not almost parallel to the other electrode 102b.

At this point, "stand" means a state that an angle between the body part 103a (of the surface) and the non-parallel part 104a (of the surface) is not almost 0 degree (zero degree), while continuing the body part 103a and the non-parallel part 104a as one electrode 102a, obviously, "stand" means a state that an angle between the other electrode 102b and the non-parallel part 104a (of the extension) is not almost 0 degree(that is, the state that the non-parallel part 104a is not almost parallel to the other electrode 102b) too.

Furthermore, if the angle between the body part 103a and the non-parallel part 104a is not almost 0 degree, the angle may be any value, for example, the angle may be almost 90 degrees (that is, the non-parallel part 104a is almost orthogonal to the body part 103a (and the other electrode 102b), besides, the angle may be a predetermined angle including 30 degrees, 45 degrees, 60 degrees and so on.

We describe the standing of the non-parallel part 104a, the standing non-parallel part 104a in a cross sectional view may be linear, besides, be curved.

Such non-parallel part 104 may stand on at least the end in the body part 103a.

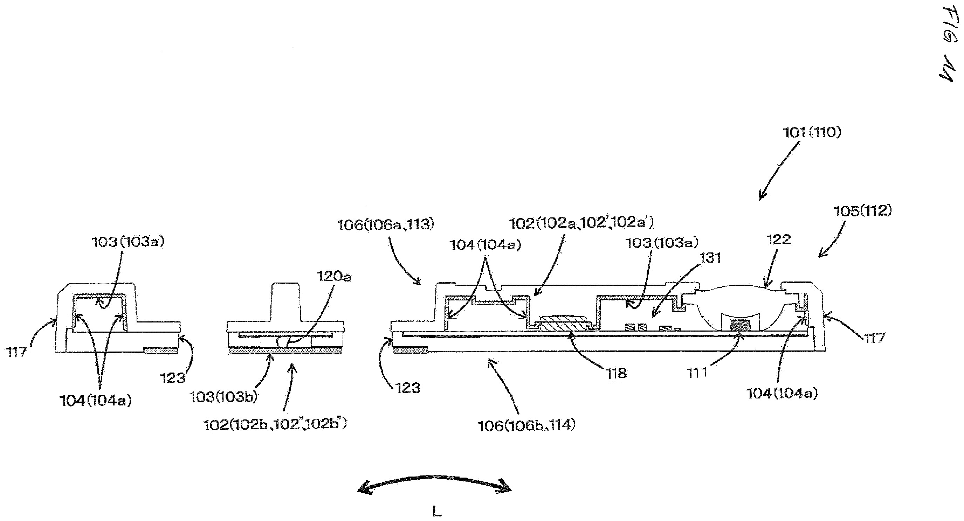

We describe in detail, the non-parallel part 104a may be stand on only any one end in the body part 103a, besides, for example, if the body part 103a is approximate plate-like shape body et cetera including an approximate rectangular shape, an approximate square shape, the non-parallel part 104a may stand on two ends, three ends or four of the four ends (a circumferential end) all (refer to Figure 9 (b), Figure 11).

As shown in Figure 11 in particular, in a case that the non-parallel part 104 is standing on the end (the upper and lower end) of the body part 103a almost orthogonal to a longer direction L of the electric path R, for example, if the electric path R is curved in the forward and backward direction (a direction bringing close and separating to the electroscope 110, like a two-way arrow indicated by symbol L in Figure 11), it is easy to capture the electric field E generated by the energization of the electric path R without omission.

And, if the body part 103a is approximate plate-like shape body et cetera including an approximate circle shape, an approximate ellipse shape, the non-parallel part 104a may start on only one part of the circumferential end, or the non-parallel part 104a may stand on the entire circumferential end.

The non-parallel part 104a may be formed (stand) in not only the end of the body part 103a, on but also the middle part (a portion except the end) of the body part 103a.

At this point, the side face of the ruggedness formed on the middle part of the above-mentioned body part 103 may be regarded as the non-parallel part 104a.

### <Casing 105, Body side part 106, Joint side part 107 of the capacitor unit 101>

As shown in Figures 9 to 12, 15, 16, the casing (the capacitor casing) 105 of the capacitor unit 101 is what holds the one pair of the electrodes 102a, 102b (a housing).

The casing 105 comprises a pair of body side parts 106 (106a, 106b) holding the body parts 103a, 103b of the one pair of the electrodes 102a, 102b, and a joint side part 107 standing from the end of each the body side part 106a, 106b and joining together between the one pair of the body side parts 106a, 106b.

If the casing 105 comprises the above body side parts 106a, 106b and the joint side part 107, the casing 105 may be any constitution, the shape of the casing 105 may be an approximate rectangular parallelepiped body, an approximate cube body, and an approximate column, an approximate ellipse body, approximate triangle pole, approximate hexagonal pole.

Below, we describe that the casing 105 is an approximate rectangular parallelepiped body, in this case, it can be said that the largest two face sides placing opposite are the body side parts 106a, 106b, and the face side remaining four are joint side parts 107, in the approximate rectangular parallelepiped body.

The casing 105 may be provided a window and a mounting hole 123 et cetera for the light-emitting part 111 described later.

We describe material of the casing 105, if the electric potential difference is generated between the one pair of the electrodes 102a, 102b at the time of positioning the casing 105 in a predetermined electric field E, the material of the casing 105 is not limited in particular, for example, the material of the casing 105 may be a non-conductive material including a synthetic resin-made, a wood-made, a ceramics-made material.

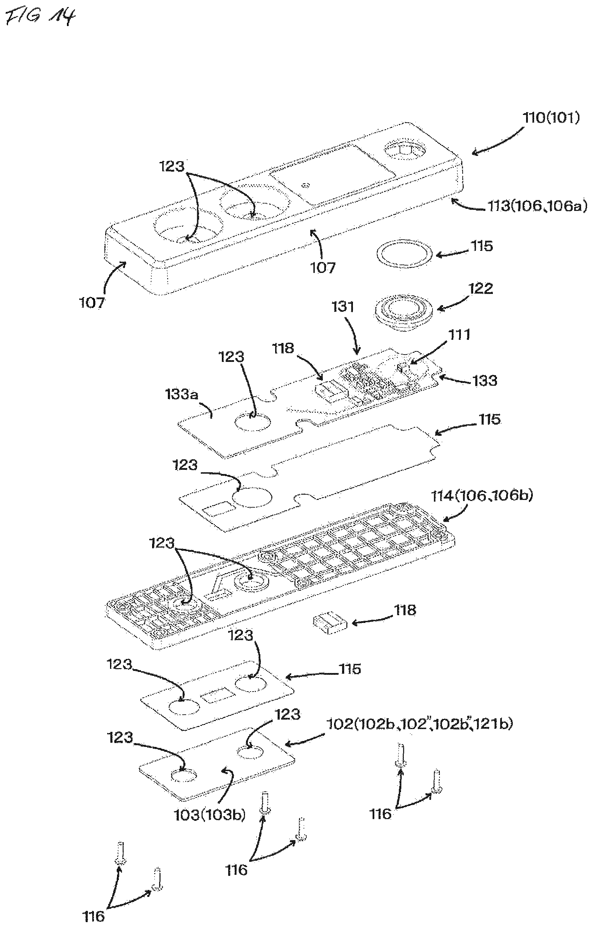

Furthermore, the casing 105 may be a constitution that the (four) joint side parts 107 are integrated to the one body side part 106a et cetera (refer to Figure 9 (b)), the casing 105 may be a constitution fixing the other body side part 106b to the one body side part 106a and the joint side part 107 with a predetermined number of screws 116 et cetera (refer to Figure 14), may be a constitution fitting along groove et cetera.

### <Coated electrode 102'>

As shown in Figure 9 (b) in particular, the coated electrode 102' is constituted to coat conductive material on the inner face of the above-mentioned casing 105, the one or both of the electrodes 102a, 102b of the one pair become the coated electrode 102'.

At this point, "conductive material" may be a coated film (a vapor deposition layer) formed by vapor deposing (a vacuum vapor deposition, a chemical vapor deposition (CVD) and so on, it also is called that dry plating) a conductive material like a copper, a nickel, an iron, a copper, an aluminum, a silver, a gold, a nichrome et cetera, "conductive material" may be an conductive paint including a conductive material like a copper, a nickel et cetera, similarly, "conductive material" may be a coated film and so on formed by plating (an electro plating, a chemical plating and so on, it also is called that wet plating) a conductive material like a copper, a nickel et cetera.

Besides, "conductive material" may be a coated film and so on formed by melting, coating in a film-like shape, and sputtering a conductive material like a copper, a nickel et cetera.

The thickness of the coated electrode 102'also is not limited in particular, for example, in a case of the vapor deposition, the thickness of the vapor deposition layer may be more than 0.05 micro-meters and less than 3 micro-meters (for example, 0.1 micro-meters, 0.3 micro-meters, 1.0 micro-meters, 2.5 micro-meters and so on), in a case of the conductive paint, the thickness of the paint film may be more than 10 micro-meters and less than 50 micro-meters (20 micro-meters, 30 micro-meters, 40 micro-meters and so on).

And, in a case of plating, if a copper plating, the thickness of the coated electrode 102' (the coated film) may be more than 0.5 micro-meters and less than 3 micro-meters (for example, 0.8 micro-meters, 1.2 micro-meters, 1.5 micro-meters, 2.0 micro-meters and so on), if a nickel plating, the thickness may be more than 0.10 micro-meters and less than 0.40 micro-meters (0.25 micro-meters and so on).

Besides, the thickness of the coated electrode 102' (coated film), for example, may be more than 0.01 micro-meters and less than 50 micro-meters regardless of method.

In a case that such coated electrode 102' (102a') comprises both the body part 103 (103a) and the non-parallel part 104 (104a), the body part 103a is constituted on the inner face of the body side part 106a of the casing 105, the non-parallel part 104a is constituted on the inner face of the joint side parts 107 of the casing 105.

At this point, the non-parallel part 104a constituted on the inner face of the joint side parts 107, obviously, is coated only a range not contacting the other electrode 102b.

That is, the coated electrode 102a' just have to be constituted that the non-parallel part 104a is across the body side part 106a and the joint side parts 107, and it coats at least a portion closer to the one body side part 106a in the joint side parts 107, it does not necessarily coat all the inner face of the joint side parts 107.

On the other hand, in a case that the coated electrode 102a' comprises only the body part 103a, like the above-mentioned, the body part 103a is constituted on only the inner face of the body side part 106a of the casing 105.

Furthermore, if only the one electrode 102a of the one pair of the electrodes 102a, 102b is the coated electrode 102', the other electrode 102b is constituted by something except the coated electrode 102' (metal plate 102"described later).

Below, we describe this metal plate 102".

### <Metal plate 102">

As shown in Figure 9, Figure 10 (a), Figure 14 et cetera in particular, in a case that the one electrode 102a of the one pair of the electrodes 102a, 102b is the above-mentioned coated electrode 102', the metal plate 102"constitutes the other electrode 102b.

The metal plate 102" (102b") is conductive metal-made including an iron, a copper, an aluminum, a silver, a gold, a nichrome et cetera.

In a case that such metal plate 102b"comprises both the body part 103 (103b) and the non-parallel part 104 (104b), the end et cetera of one metal plate 102"may be folded to be regarded as the non-parallel part 104b, it may constitute that the non-parallel part 104b is jointed by welding et cetera, like non-parallel to the body part 103b.

On the other hand, in a case that the metal plate 102b"comprises only the body part 103b, obviously, the shape of the metal plate 102b" is an approximate plate-like shape body. Furthermore, the mounting hole 123 et cetera described later may be provided in the metal plate 102b".

### <Modified example of the capacitor unit 101 of thelst embodiment>

A most different point between the 1st embodiment and the modified example of the capacitor unit 101 of the 1st embodiment of the present invention is a point that the body parts 103 (103a, 103b) are curved in the one pair of the electrodes 102a, 102b.

We describe in detail, the modified example, for example, encloses like curved the electric path R of a sectional approximate circle shape (or a sectional approximate ellipse shape) et cetera including a cable and so on described later, the one pair of the body parts 103a, 103b is almost concentric circular arc shape, like enclosing go around the electric path R in a cross sectional view.

Thus, in a case the one pair of the body parts 103a, 103b are curved, because it also can be said that at arbitrary spots placing opposite to (facing each other) or arbitrary spots bringing closest mutually in the one pair of the electric conductors, distances between the arbitrary spots are almost same, the body parts 103a, 103b are almost parallel mutually.

Thus, it can be said that it captures a predetermined electric field E which spreads radially as going away from the electric path R (for example, the electric field E generated by the energization of electric path R described later and so on) without more omission, according to curving the one pair of the body parts 103a, 103b.

Other constitution, operation, effect and use mode of the capacitor unit 101 of the modified example of thelst embodiment are same as the 1st embodiment.

### <Capacitor unit 101 of the 2nd embodiment>

Figure 10 (b) shows the capacitor unit 101 of the modified example of the 2nd embodiment of the present invention.

A most different point between the 1st embodiment and the 2nd embodiment is a point that the non-parallel parts 104 (104a, 104b) are provided in both the electrodes 102a, 102b of the one pair (the non-parallel parts 104a, 104b are one part of each electrode 102a, 102b).

Thus, it also can be said that it can capture, for example, a predetermined electric field E which spreads radially as going away from the electric path R without more omission, just as much as comprising the non-parallel parts 104a, 104b in each of two electrodes 102a, 102b, according to both the electrode 102a, 102b's having the non-parallel parts 104a, 104b.

Other constitution, operation, effect and use mode of the capacitor unit 101 of the 2nd embodiment are same as the 1st embodiment and the modified example of thelst embodiment.

### <Electroscope 110 of the 2nd embodiment>

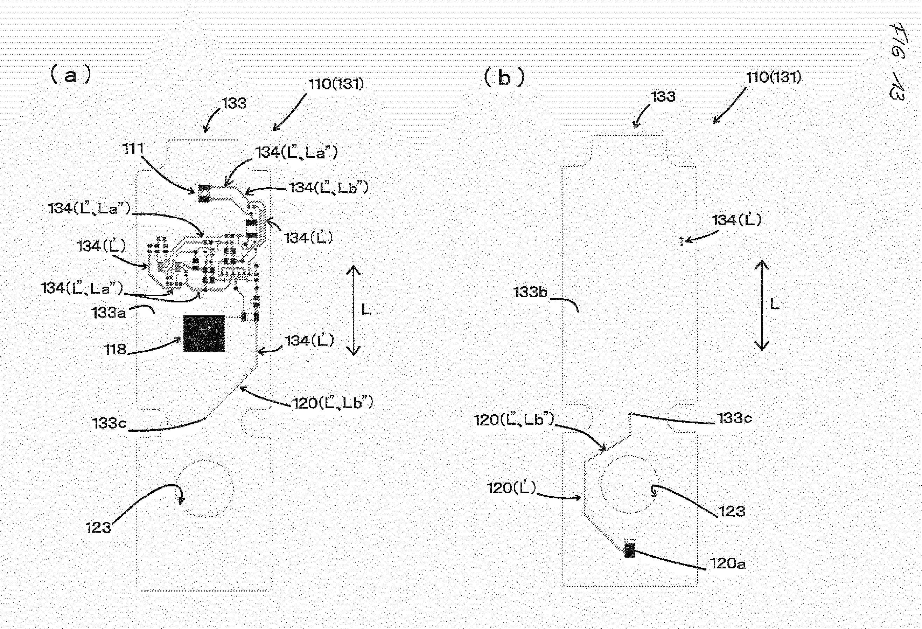

As shown in Figures 9 to 17, the electroscope 110 of the 2nd embodiment comprises the capacitor unit 101 of the 1st, 2nd embodiments et cetera, the electroscope 110 inspects energization of the electric path R using the output electric current Y from the capacitor unit 101.

The electroscope 110 comprises a light-emitting part 111 which lights on by the electric current generated by electric potential difference between the one pair of the electrodes 102 (102a, 102b) of the capacitor unit 101, at the time of making the electroscope 110 positioned in electric field E generated by the energization of the electric path R.

And, in the capacitor unit 101 of the electroscope 110, the one electrode 102a of the one pair of the electrodes 102a, 102b may be the coated electrode 102' (102a') comprising the body part 103 and the non-parallel part 104, the other electrode 102b may be the metal plate 102"(102b") comprising only the body part 103.

Moreover, in the capacitor unit 101 of the electroscope 110, the one coated electrode 102a' of the one pair of electrodes 102a, 102b may be positioned farther than the other metal plate 102b"from the electric path R, the body part 103a of the one coated electrode 102a'may be almost the same size as or greater than the body part 103b of the other metal plate 102b".

### <Casing 112 of the electroscope 110 of the 2nd embodiment>

As shown in Figures 9, 14 in particular, the casing (the electroscope casing) 112 of the electroscope 110 is used also as the casing (the capacitor casing) 105 of the above-mentioned capacitor unit 101.

We describe in detail, the electroscope casing 112 is built in circuit board 133 implementing the charging and discharging circuit 131 described later too, the electroscope casing 112 comprises a chassis 114 supporting a cover (a lid, a front face) 113 side and the circuit board 133.

Among these, the cover 113 is the one body side part 106a and the four joint side parts 107 holding the above-mentioned the one coated electrode 102a', these side part 106a, 107 are integrally formed.

The one coated electrode 102a' is held and constituted (refer to Figure 9 (b)), according to coating conductive material on the inner face of the cover 113 (the one body side part 106a and the joint side parts 107).

In contrast, the chassis 114 is holding the above-mentioned the other metal plate 102"by the back face side of the chassis 114, the chassis 114 is the other body side part 106b.

And, the circuit board 133 and the chassis 114, the chassis 114 and the other metal plate 102"may be stuck by double sided tape 115, the chassis 114 and the cover 113, like the above-mentioned, may be fixed with a predetermined number of screws 116.

Besides, the electroscope 110 may comprise the charging and discharging circuit 131 charging and discharging electric current from the capacitor unit 101, if the electric path R described later is the alternating electric path R', the electroscope 110 may comprise a rectifier 117 which converts alternating electric current to direct electric current.

And so, in the first place, we describe the electric path R inspected the energization by such electroscope 110 in detail.

### <Electric path R (Alternating electric path R'), Electric field E and so on>

As shown in Figures 10 to 13, 15 to 17, the electric path R is a path of electric current comprising a longer direction L, or electric circuit, the electric path R is inspected whether it is electrically conducted with, whether electric current is made to flow (whether it is energized) by the electroscope 110, the electric path R is an electric conductor of a copper, an aluminum, a silver, a gold, a nichrome et cetera, the electric path R includes a cable, a typical electric wire and so on covered the electric conductor by insulating material.

Electric current being made to flow in the electric path R may be any of alternating electric current, direct electric current, the electric path flowing alternating electric current is an alternating electric path R', the electric path flowing direct electric path is an direct electric path R".

If the electric path R flows electric current, the electric path R may be any constitution, for example, the alternating electric path R' may be three-phase cables (a piece of two pieces of those cables), or bus bar(refer to Figures 9, 14, 17), which have a predetermined voltage (for example, if high voltage, 6600V, 22000V and so on, if low voltage, 100V to 200V and so on) in electric power distributors of solar power generation plants (solar power generating stations).

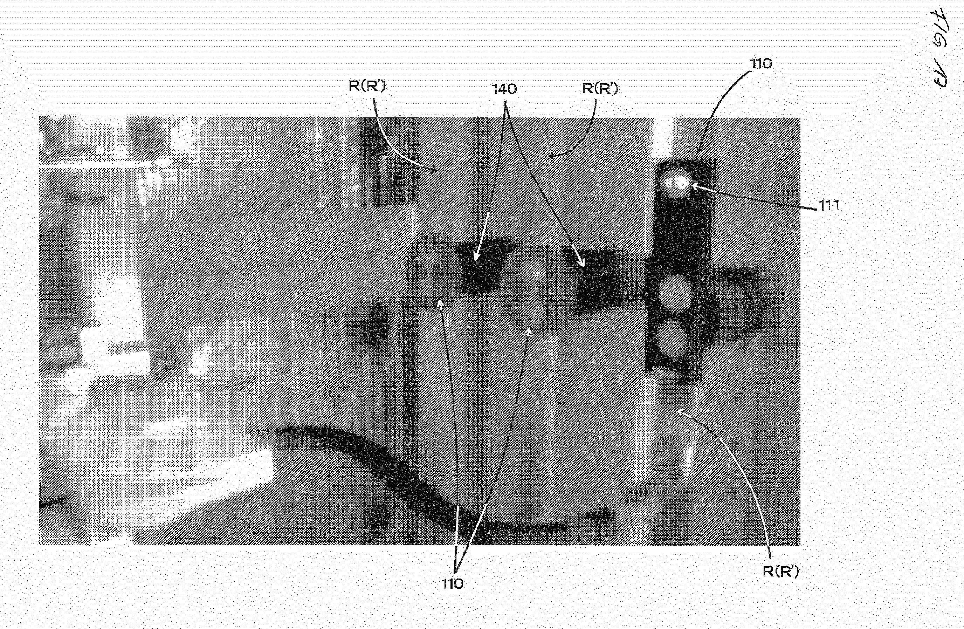

Furthermore, as shown in Figure 17, the inside of the electric power distributors is dim, if through the cover moreover, it is difficult to confirm the position of the alternating electric path R'. However, it can show state which is energized for a user easily by the light-emitting part 111 of the electroscope 110.

As other example of the alternating electric path R', the alternating electric path R' may be an electrical outlet, a breaker provided in a house, a building as commercial power supply, including a power transmission facility and so on.

On the other hand, as example of the direct electric path R", the direct electric path R" may be many solar battery panels in the solar power generation plant, many solar battery strings connected a plurality of the solar battery panels in series, direct electric current cables in connection boxes collecting the plurality pieces of the solar battery strings.

As other example of the direct electric path R", the direct electric path R" may be electric appliances flowing the direct electric current, including a computer of desktop type, notebook type and so on, office equipment, every kind terminal device and so on.

Below, we describe the electric path R is the alternating electric path R' (in particular, the three-phase cable of 6600V, 22000V).

### <Role of the capacitor unit 101 of the electroscope 110 of the 2nd embodiment>

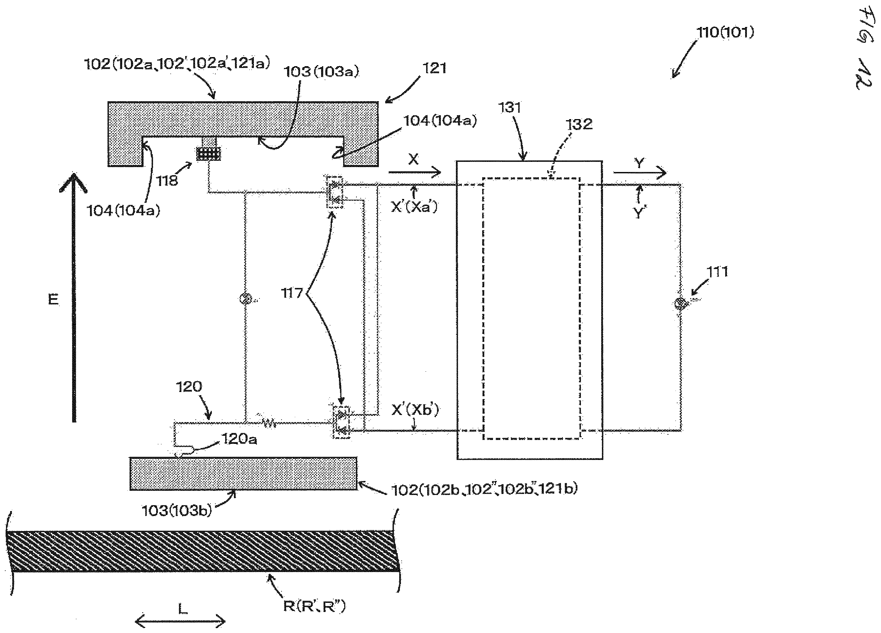

As shown in Figure 12, role of the capacitor unit 101 of the electroscope 110 is to regard electric current from the one pair of the electrodes, as the input electric current X to the charging and discharging circuit 131 described later.

More specifically, the one coated electrode 102a' and the other metal plate 102b"in the capacitor unit 101 are connected to the input wiring X to the charging and discharging circuit 131, when the one pair of electrodes 102 (the coated electrode 102a' and the metal plate 102b") is positioned in the electric field E generated by the energization of the above-mentioned electric path R (the alternating electric path R' et cetera), the electric potential difference is generated between the one pair of the electrodes 102a', 102b".

Consequently, it also can be said that the one pair of the electrodes 102a', 102b" is the gate capacitor 121 (the one pair of the gate electrodes 121a, 121b).

The coated electrode 102a', which is the gate electrode 121a of the cover 113 side, may be connected to the one input wiring X' (Xa') of the charging and discharging circuit 131 through a gate contactor (for example, a gasket and so on which winds conductive cloth to polyurethane foam).

And, the metal plate 102", which is the gate electrode 121b of the chassis 114 side, may be mounted to a concave part provided in the back face side of the chassis 114 through a double sided tape 115, the metal plate 102"may be connected to the other input wiring X' (Xb') of the charging and discharging circuit 131 through a gate electrode wiring 120.

This gate electrode wiring 120 may be wired from a components face (front face) 133a side of the circuit board 133 in the charging and discharging circuit 131, through a penetrating hole 133c, to a solder face (reverse face) 133b side, the gate electrode wiring 120 may be connected to the metal plate 102"of the back face side of the chassis 114 through a wiring terminal 120a.

### <Rectifier 117>

As shown in Figure 12, the rectifier 117 is what converts the alternating electric current from the alternating electric path R' to the direct electric current (the rectifier 117 are shown by D1 and D2 in Figure 12).

If the rectifier 117 can convert the alternating electric current from the alternating electric path R' to the direct electric current, the rectifier 117 may be any constitution, for example, the rectifier 117 may use two of what is combined two diode members to one element.

### <Charging and discharging circuit 131>

As shown in Figure 12 et cetera, the charging and discharging circuit 131 is the circuit which charges an electric current (an input electric current X) from the capacitor unit 101 (the gate capacitor 121) to another electric storage device 132, and makes the light-emitting part 111 described later lights on by an electric current (an output electric current Y) discharged from the electric storage device 132.

If the charging and discharging circuit 131 makes the electric current from the gate capacitor 121 charges and discharges to the electric storage device 132, the charging and discharging circuit 131 may be any constitution, for example, the electric storage device 132 may be different charge capacitor 132 from the gate capacitor 121.

Moreover, the charging and discharging circuit 131 may comprise a plurality of the charge capacitors 132, the charging and discharging circuit 131 may be a constitution that the plurality of the charge capacitor 132 are connected in series at the time of charging, and in parallel at the time of discharging.

Furthermore, the number of the charge capacitors 132 may be may be two, three and four or more and so on, if the number is plurality, the number may be any value.

The static capacitance of each charge capacitor 132 is not limited in particular, for example, may be more than 0.001 micro-farads and less than 10000.000 micro-farads, preferably may be more than 0.01 micro-farads and less than 5000.00 micro-farads, more preferably may be more than 0.1 micro-farads and less than 1000.00 micro-farads (2.2 micro-farads and so on).

Moreover, a dielectric, that relative dielectric constant is greater than 1, may be hold between the electrodes of the charge capacitors 132, the state between the electrodes may be the state that the relative dielectric constant is 1 (that is, the state that there is vacuum between the electrodes) and so on, the state between the electrodes may be any state.

Furthermore, each charge capacitor 132 may be what some of capacitor members gather.

Each element of the charge capacitor 132 and so on of the charging and discharging circuit 131, am element wiring 134 connecting the elements, other elements (for example, a lightning surge protection element and so on) are arranged on the components face (front face) 133a side of the above-mentioned circuit board 133.

Thus, in the circuit board 133 of the charging and discharging circuit 131, the element wiring 134, the above-mentioned gate electrode wiring 120 et cetera are arranged, the wirings L' almost parallel to a longer direction L of the electric path R of these wirings 120, 134 is fewer than the wirings (non-parallel wirings) L" not almost parallel to the longer direction L of the electric path R.

At this point, "the wirings L' almost parallel to the longer direction L of the electric path R is fewer than the wirings L" not almost parallel to the longer direction L of the electric path R" includes a case that the number of the wirings L' almost parallel to the longer direction L of the electric path R is fewer than the number of the wirings L" not almost parallel to the longer direction L of the electric path R, in the wirings 120,134 of the circuit board 133 of the charging and discharging circuit 131, and a case that the total length summed the length of all wirings L' almost parallel to the longer direction L of the electric path R is fewer (shorter) than the total length summed the length of all wirings L" not almost parallel to the longer direction L of the electric path R, or, both the cases at the same time and so on, "the wirings L' almost parallel to the longer direction L of the electric path R is fewer than the wirings L" not almost parallel to the longer direction L of the electric path R" includes any cases.

Furthermore, the wirings L" not almost parallel to the longer direction L of the electric path R means a wiring La" almost orthogonal to the longer direction L of the electric path R in the plane view (or in the front view), and a wiring Lb" and so on intersecting obliquely with the longer direction L of the electric path R.

### <Light-emitting part 111>

As shown in Figures 12 to 17, the light-emitting part 111 is what shows by light a state that the electric path R (the alternating electric path R' et cetera) is energizing (the light-emitting part 111 is shown by LED1 in Figure 12), using the output electric current Y discharged from the charging and discharging circuit 131 (the charge capacitor 132).

The light-emitting part 111 may show the state that the alternating electric path R' et cetera is energizing by flickering light and so on, the light-emitting part 111 may be any constitution, the light-emitting part 111 is connected to the output wiring Y' of the above-mentioned charging and discharging circuit 131.

The light-emitting part 111, specifically, may be a light-emitting diode (LED), an organic EL (an organic electro-luminescence), a neon lamp and the like, and if what emits light, the light-emitting part 111 may be a discharge lighting, like a halogen lamp, an incandescent light bulb, a fluorescent lamp (a fluorescent lighting), a mercury lamp (a mercury lighting) et cetera.

Below, we mainly describe that the light-emitting part 111 is a light-emitting diode.

The light-emitting part 111 may be a constitution emitting light (lighting on) in a predetermined light-emitting period T by the above-mentioned charging and discharging circuit 131, a duty ratio D of the light-emitting time T' of the light-emitting part 111 against the light-emitting period T (that is, the duty ratio D = (the light-emitting time T') / (the light-emitting period T)) may be more than 0.000001 and less than 0.500000.

Furthermore, when the light-emitting part 111 is built in the casing (electroscope casing) 112 of the electroscope 110, a lens 122 may be covered on the light-emitting part 111, this lens 122 and the cover 113 of the electroscope casing 112 may be stuck mutually by double sided tape 115.

### <Usage of the electroscope 110 of the 2nd embodiment >

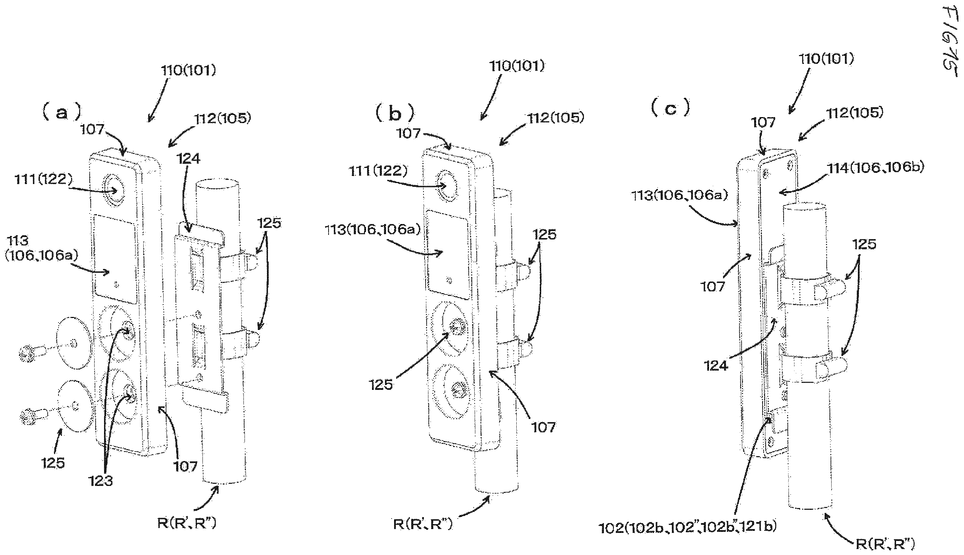

As shown in Figures 15 to 17 et cetera, at the time of usage of the 2nd embodiment of the electroscope 110, the electroscope 110 may be mounted to the electric path R by fixing means in accordance with the mode (a cable or a bus bar and so on) of the electric path R.

In particular, as shown in Figure 15, for example, in a case that the electric path R is a cable, a bracket (a bracket metal plate) 124 may be mounted to the cable using fixing means 125 of a hose band et cetera, the electroscope 110 may be mounted to the electric path R using fixing means 125 of bolt, washer et cetera against a mounting hole 123 penetrating one end part (a lower part) of the electroscope casing 112, in a state bringing close and approaching the back face side of the electroscope casing 112 to the electric path R through the bracket 124.

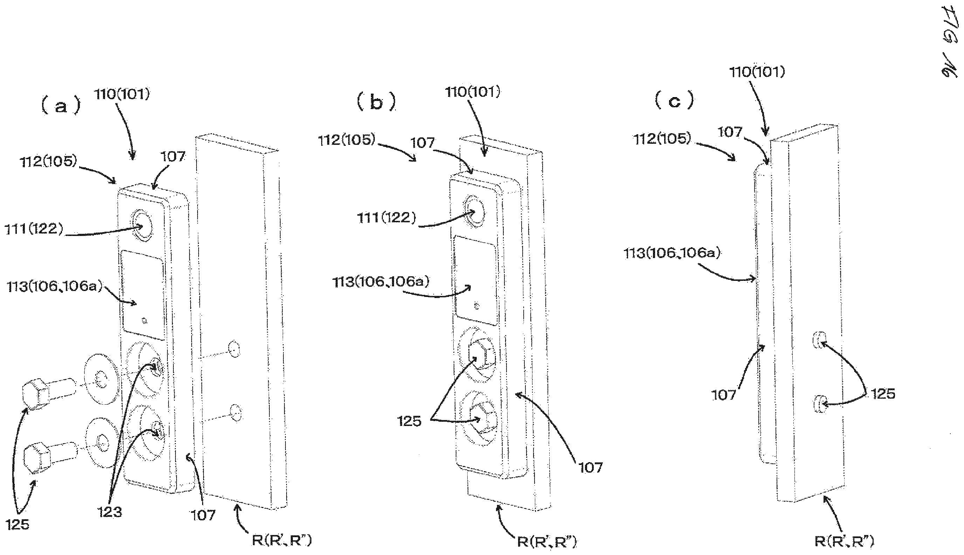

And, in particular, as shown in Figures 16, 17, for example, in a case that the electric path R is a bus bar of sectional approximate rectangular shape et cetera, screw holes are provided in the bus bar, the electroscope 110 may be mounted to the electric path R using the fixing means 125 against the mounting holes 123 of the electroscope casing 112 in a state bringing close and approaching the back face side of the electroscope casing 112 to the electric path R through the screw holes.

Besides, groove 126 is formed at one end part of the electroscope casing 112, the electroscope 110 may be mounted to the electric path R using fixing means 125 of a cable tie (refer to Figure 9 (a)) et cetera along the groove.

### <Other member of the electroscope 110 of the 2nd embodiment>

As shown in Figure 12, the electroscope 110 of the 2nd embodiment may comprise the above-mentioned charging and discharging circuit 131, the charge capacitors 132, the element wiring 134, the gate electrode wiring 120, the light-emitting part 111, the rectifier 117 et cetera, in addition to a resistor member, a lightning surge protection element and so on, below, examples are described.

R1 and Z1 in Figure 12 are elements for lightning protection, in the first place, it can be said that the resistor member of the R11 prevents high voltage to be applied instantly to a circuit after the rectifier 117, it can be said that when voltage between the terminals in the internal resistor of the rectifier 117 increases, a lightning surge protection element of the Z1 prevents ascending of terminal voltage by electric current is made to flow to earth.

### <The others>

The present invention is not limited the above-mentioned embodiments. Each constitution, whole construction, shape and/or dimension of the charging and discharging circuit 1, the electroscope 20 of the 1st embodiment, the capacitor unit 101, the electroscope 110 of the 2nd embodiment et cetera can change appropriately in accordance with a purport of the present invention.

### <Charging and discharging circuit 1 and the electroscope 20 of the 1st embodiment>

The charging and discharging circuit 1 may comprise a switch to not flow the input electric current X to the capacitors 2 (a charge propriety switch et cetera).

Contrary to the mainly above-mentioned case, in a case that the plurality of the capacitor 2 is in the parallel electric current state J2 at the time of charging, the plurality of the capacitor 2 is in the series electric current state J1 at the time of discharging (it becomes from low voltage to high voltage), a side which was the output wiring Y' in the above charging and discharging circuit 1 becomes the input wiring X' side, a side which was the input wiring X' in the above charging and discharging circuit 1 becomes the output wiring Y' side.

In a case that the plurality of the capacitors 2 is in the parallel electric current state J2 at the time of charging, the plurality of the capacitor 2 is in the series electric current state J1 at the time of discharging, any one of the intermediate diodes 6 in the series wiring 5 becomes the change-over switch 3, the change-over switches 3 in the parallel wirings 9A, 9K becomes the diodes for parallel 10.

In this case, the anode end outside electrode 8A side of the anode end capacitor 2A becomes the GND side, if the discharge switch 4 is the low side switch, the gate (G) and the drain (D) of the discharge switch 4 of the N-channel MOSFET are connected as the above, the source (S) of the discharge switch 4 is connected to the anode end outside electrode 8A which is the output wiring Y' of the high electric potential side of the charging and discharging circuit 1.

On the other hand, in a case that the plurality of the capacitor 2 is in the parallel electric current state J2 at the time of charging, the plurality of the capacitor 2 is in the series electric current state J1 at the time of discharging, if the discharge switch 4 is the high side switch, the gate (G) and the drain (D) of the discharge switch 4 of the P-channel MOSFET are connected as the above, the source (S) of the discharge switch 4 is connected to the cathode end outside electrode 8K which is the output wiring Y' of the GND side of the charging and discharging circuit 1.

Moreover, in this case, the timer power supply wiring 13 is a wiring connecting the power supply terminal 12 of the timer part 11 to the diode-capacitor interval 7D, which is between the anode end capacitor 2A of the above-mentioned series wiring 5 and the intermediate diode 6 adjacent to the capacitor 2A, the diode for power supply 14 is arranged in a forward direction same as the above in the timer power supply wiring 13.

The number of the capacitor 2, like the above-mentioned, if plurality, the number of the capacitors 2 may be two, three, four or more, in Figure 1, the number of the capacitors 2 is four (C1 to C4 in Figure 1). In a case that the number of the capacitors 2 is three (a case deleting a dotted line indicated by symbol A in Figure 1), it is unnecessary to implement the capacitor 2 of C1 (the anode end capacitor 2A of the series wiring 5), Zener diode connecting in parallel to the capacitor 2 of C1 (D2 in Figure 1), the change-over switch 3 of Q1, a diode of D3 (the diode for parallel 10 adjacent the anode end capacitor 2A, the intermediate diode 6).

Furthermore, in this case, the resistor value of R1 in Figure 1 is 0 ohm (that is, substantially, only wiring without resistor).

We describe this R1 in Figure 1 moreover, in a case that the number of the capacitor 2 is four, the resistor value of R1 may be large resistor value sufficiently (for example, several mega-ohms and so on), that is, substantially, this R1 is not electrically conducted.

Besides, when the input electric current X is not input in the charging and discharging circuit (when the electroscope 20 leaves the electric field E of the electric path R which is energizing (the alternating electric path R' et cetera) and so on), the output electric current Y may continue to be discharged from the plurality of the capacitors 2, after a predetermined time (for example, after about 10 seconds), electric charge charged to each capacitor 2 may become 0 (zero), that is, the capacitor 2 may finish to discharge.

### <Insulator 40>

As shown in Figure 8, the electroscope 20 of the 1st embodiment may be mounted to an insulator 40.

At this time, the one pair of the gate electrodes 21 (the gate capacitors 21') is built in the insulator 40, a dielectric, that relative dielectric constant is greater than 1 (a synthetic resin including an epoxy resin, a PET resin, a nylon resin et cetera, and material including a quartz glass, a ceramics and so on), may be hold between the gate electrodes 21.

Thus, the insulator is mounted to the alternating electric path R' can be used also as the electroscope, it can attain space-saving, according to building the gate capacitor 21' in the insulator 40, and mounting the electroscope 20 of the 1st embodiment to the insulator 40.

If the insulator 40 insulates between the electric path R (the alternating electric path R' et cetera) and a supporting material, the insulator 40 is built in the gate capacitor 21', the insulator 40 may be any constitution.

Furthermore, only low electric potential side (a side except the electric path R side) of the gate electrodes 21a, 21b of the gate capacitor 21' is connected to high electric potential side (for example, the one input wiring Xa') of the charging and discharging circuit 1, the low electric potential side (for example, the other input wiring Xb') of the charging and discharging circuit 1 is earthed (is connected to GND).

The electroscope 20 of the 1st embodiment may be a constitution that it can be mounted later to the electric path R inspected (electrically detected) a state of energization (the alternating electric path R', the direct electric path R"), and the electroscope 20 may be mounted the electric path R from the beginning of production.

The electroscope 20 may be a constitution that the electroscope 20 constantly performs electric detection, after mounted once to the electric path R, just as it is mounted, the electroscope 20 may be a constitution that the electroscope 20 is mounted to the electric path R only at the time of detecting electricity.

And, if the electric path R is the direct electric path R", the above-mentioned rectifier 23 becomes unnecessary in the electroscope 20.

### <Capacitor unit 101 and the electroscope 110 of the 2nd embodiment>

The non-parallel part 104 of the capacitor unit 101 or the electroscope 110 of the 2nd embodiment is provided in at least the one of the one pair of the electrodes 102, and the non-parallel part 104 may stand on only one end of the body part 103 (that is, only the one non-parallel part 104 stands) in a cross sectional view, against each electrode 102, the non-parallel parts 104 may stand on both end of the body part 103 (that is, the two non-parallel parts 104 stands), furthermore, the non-parallel parts 104 may stand on both end or one end of the body part 103, in addition to the one or plurality non-parallel parts 104 may stand on the middle part of the body part 103 (that is, the two or three or more non-parallel parts 104 stands in total).

Both the electrodes 102a, 102b of the one pair of the capacitor unit 101 or the electroscope 110 may be the metal plates 102"

Both the electrodes 102a, 102b of the one pair of the capacitor unit 101 (the gate capacitor 121) of the electroscope 110 of the2nd embodiment may be positioned at almost the same distance from the electric path R, in a case that each electrode 102a, 102b of the one pair is positioned at different distance from the electric path R, contrary to the above, the one electrode 102a positioned in far side from the electric path R may be smaller than the other electrode 102b positioned in closer side from the electric path R.

And, both the electrodes 102a, 102b of the one pair of the gate capacitor 121 of the electroscope 110 may comprise the non-parallel part 104.

The electroscope 110 don't have to comprise the charging and discharging circuit 131, the electroscope 110 may be a constitution that the electroscope 110 lights on the light-emitting part 111 by flowing electric current directly to the light-emitting part 111, without charging electric current by the electric potential difference generated between the one pair of the electrodes 102 of the gate capacitor 121, to the capacitor et cetera.

The electric storage device 132 in the charging and discharging circuit 131 may be something except the charge capacitor 132, the storage battery (battery) 132 including a lead storage battery, a lithium ion storage battery, a nickel-hydrogen storage battery, a nickelcadmium storage battery and so on.

The charging and discharging circuit 131 may be a circuit except a circuit that the plurality of the charge capacitors 132 is connected in series at the time of charging, the plurality of the charge capacitors 132 is connected in parallel at the time of discharging, for example, the charging and discharging circuit 131 may be a circuit that a comparator detects that charge voltage of the charge capacitor 132 exceeds a predetermined value, the light-emitting part 111 is lighted on, when the charge voltage of the charge capacitor 132 becomes less than the predetermined value by lighting on the light-emitting part 111, the light-emitting part 111 is lighted off, it waits charging of the charge capacitor 132 again, the charging and discharging circuit 131 may be any constitution.

Furthermore, in the case of the above circuit using the comparator, the number of the charge capacitor 132 may be not plurality, but one.

The circuit board 133 of the charging and discharging circuit 131 of the electroscope 110 may be removed insulating film around the above-mentioned mounting hole 123.

### <Insulator 140>

As shown in Figure 17, the electroscope 110 of the 2nd embodiment may be mounted to the insulator 140.

At this time, the gate capacitor 121 (capacitor unit 101) of the electroscope 110 is built in the insulator 140, a dielectric, that relative dielectric constant is greater than 1 (a synthetic resin including an epoxy resin, a PET resin, a nylon resin et cetera, and material including a quartz glass, a ceramics and so on), may be hold between the gate electrodes 121a, 121b.

Thus, the insulator is mounted to the alternating electric path R' can be used also as the electroscope, it can attain space-saving, according to building the gate capacitor 121 in the insulator 140, and mounting the electroscope 110 to the insulator 140.

If the insulator 140 insulates between the electric path R (the alternating electric path R' et cetera) and a supporting material, the insulator 140 is built in the gate capacitor 121, the insulator 140 may be any constitution.

Furthermore, only low electric potential side (a side except the electric path R side) of the gate electrodes 121a, 121b of the gate capacitor 121 is connected to high electric potential side (for example, the one input wiring Xa') of the charging and discharging circuit 131, the low electric potential side (for example, the other input wiring Xb') of the charging and discharging circuit 131 is earthed (is connected to GND).

Furthermore, the charging and discharging circuit 131 may be the charging and discharging circuit 1 of the above-mentioned 1st embodiment, the 2nd embodiment.

The electroscope 110 of the 2nd embodiment may be a constitution that it can be mounted later to the electric path R inspected (electrically detected) a state of energization (the alternating electric path R', the direct electric path R"), and the electroscope 110 may be mounted the electric path R from the beginning of production.

The electroscope 110 may be a constitution that the electroscope 110 constantly performs electric detection, after mounted once to the electric path R, just as it is mounted, the electroscope 110 may be a constitution that the electroscope 110 is mounted to the electric path R only at the time of detecting electricity.

And, if the electric path R is the direct electric path R", the above-mentioned rectifier 117 becomes unnecessary in the electroscope 110.

### <Series wiring 5', the parallel wirings 9A', 9K' and so on, regarding the stepped up charging and discharging circuit 1>

The charging and discharging circuit 1, (in particular, in Figure 3) like the above-mentioned, may be a constitution that the plurality of the capacitor 2 is switched to the parallel electric current state J2 at the time of charging by the above change-over switches 3, the plurality of the capacitor 2 is switched to the series electric current state J1 before discharging by the change-over switches 3, after switching to the series electric current state J1, the plurality of the capacitor 2 starts discharging of the output electric current Y by the discharge switch 4, in a case of changing and discharging in such order, after charging in parallel the plurality of the capacitors 2 in a predetermined voltage, it becomes to discharge in series electric current in a voltage higher than the predetermined voltage from the plurality of the capacitors 2, it becomes to discharge the output electric current Y which steps up the voltage from low voltage to high voltage according to the input electric current X's pathing through the charging and discharging circuit 1.

We describe the series wiring 5' of the charging and discharging circuit 1 which steps up from low voltage to high voltage, the parallel wirings 9A', 9K' and so on.

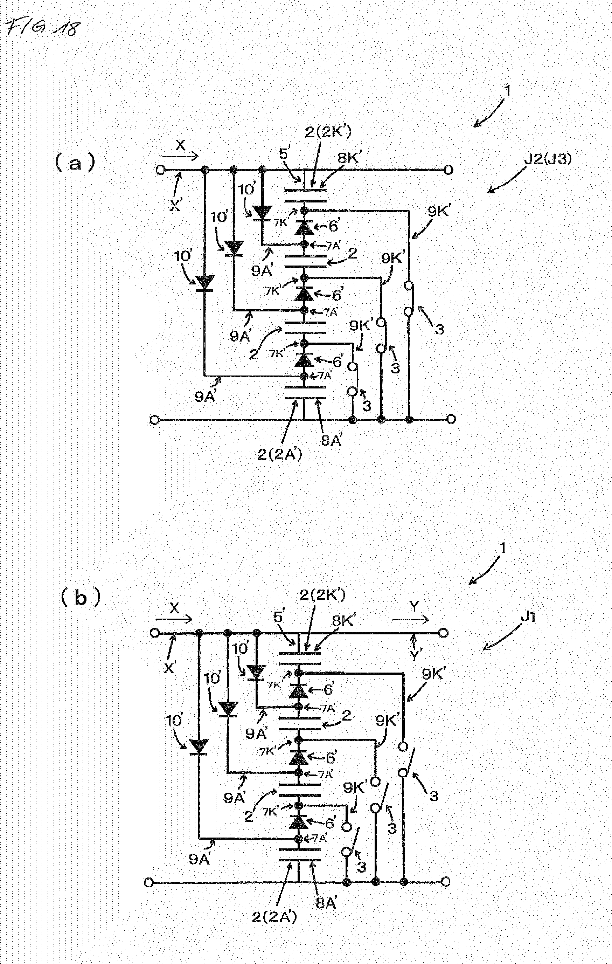

As shown in Figure 18, the series wiring 5' of the charging and discharging circuit 1 which steps up also is a wiring connecting the plurality of the capacitors 2 in series, this series wiring 5', in opposite direction to the above-mentioned charging and discharging circuit 1 which steps down, intermediate diodes 6' are arranged between each set of adjacent two capacitors 2 and are aligned in a forward direction from an anode to a cathode.

Furthermore, this intermediate diodes 6' also may be one element and be independent of only intermediate diodes 6', the intermediate diodes 6' may be combined with diodes for parallel 10' in the stepped up charging and discharging circuit 1 as mentioned below, the intermediate diodes 6' and the diodes for parallel 10' may become one element.

The anode parallel wirings 9A' in the stepped up charging and discharging circuit 1 are wirings connecting each anode-capacitor interval 7A' between the anode side of the intermediate diode 6' and the capacitor adjacent to the anode side, to a cathode end outside electrode 8K' which is positioned on the end of the series wiring 5' and is positioned on the opposite side of the intermediate diode in a cathode end capacitor 2K' adjacent to only the cathode side of the intermediate diode 6'.

And, the cathode parallel wirings 9K' in the stepped up charging and discharging circuit 1 are wirings connecting each cathode-capacitor interval 7K' between the cathode side of the intermediate diode 6' and the capacitor adjacent to the cathode side, to an anode end outside electrode 8A' which is positioned on the end of the series wiring 5' and is positioned on the opposite side of the intermediate diode in an anode end capacitor 2A' adjacent to only the anode side of the intermediate diode 6'.

In the one of these two parallel wirings 9A', 9K', the change-over switches 3 are arranged, in the other, the diodes for parallel 10' are arranged.

That is, it becomes to exist three cases: <1> a case that, in the anode parallel wirings 9A', the change-over switches 3 are arranged, in the cathode parallel wirings 9K', the diodes for parallel 10' are arranged in a forward direction from the cathode-capacitor interval 7K' to the anode end outside electrode 8A', <2> a case that, in the cathode parallel wirings 9K', the change-over switches 3 are arranged, in the anode parallel wirings 9A', the diodes for parallel 10' are arranged in a forward direction from the cathode end outside electrode 8K' to the anode-capacitor interval 7A', or,<3> a case that, in the anode parallel wirings 9A' and the cathode parallel wirings 9K', the change-over switches 3 are arranged (Figure 18 shows the case of <2>).

About the cases of <1>, <2>, in particular, of the above-mentioned cases <1> to <3>, we describe in more detail that a case that the number of the capacitors 2 is three or more, each the number of the parallel wirings 9A', 9K' is two more than.

The cases of the above <1>, <2> include even a case that, regarding one stepped up charging and discharging circuit 1, in a cathode parallel wiring 9K'-1, the change-over switch 3 is arranged, and in a anode parallel wiring 9A'-1 which is the opposite side through an intermediate diode 6'-1 adjacent to the cathode parallel wiring 9K'-1, the diode for parallel 10' is arranged. At the same time this, in another cathode parallel wiring 9K'-2, inversely the diode for parallel 10' is arranged, and in a anode parallel wiring 9A-2 which is the opposite side through an intermediate diode 6'-2 adjacent to the cathode parallel wiring 9K'-2, the change-over switch 3 is arranged.

Hereinafter similarly, in moreover other cathode parallel wiring 9K'-3, the change-over switch 3 is arranged, in a anode parallel wiring 9A'-3 of the opposite side, the diode for parallel 10' is arranged et cetera, the above cases <1>, <2> may be mixed in every set of the anode parallel wiring 9A' and the cathode parallel wiring 9K'.

The plurality of the capacitors 2, which constitutes the series wiring 5, the parallel wirings 9A', 9K' in the earlier mentioned charging and discharging circuit 1, may switch to the parallel electric current state J2 by the above-mentioned change-over switches 3 at the time of charging (Figure 18(a)), may switch to the series electric current state J1 by the change-over switches 3 before discharging (Figure 18(b)), may start discharging of the output electric current Y by the discharge switch 4 after switching to the series electric current state J1.

In the case of charging and discharging in such order, after charging in parallel the plurality of the capacitors 2 in a predetermined voltage, it becomes to discharge in series electric current in a voltage higher than the predetermined voltage from the plurality of the capacitors 2, it becomes to discharge the output electric current Y which steps up the voltage from low voltage to high voltage according to the input electric current X's pathing through the charging and discharging circuit 1.

### [Industrial Applicability]

The charging and discharging circuit of the present invention can be used for an electroscope, a power supply circuit of a monitor and control device of a solar power generation, besides, an electric power source and so on, for example, of a wearable computing (to utilize a wearable computer to be worn on body), according to converting an useless or obstructive generated voltage from electric path and so on, which hitherto, it could not utilize, to an intend voltage et cetera, regardless of high voltage and low voltage.

And, the capacitor unit of the present invention can be used for an electroscope, a power supply circuit of a monitor and control device of a solar power generation, besides, an electric power source and so on, for example, of a wearable computing (to utilize a wearable computer to be worn on body), according to capturing an useless or obstructive generated voltage from electric path and so on, which hitherto, it could not utilize, without omission.

Moreover, the electroscope of the present invention can be used for a solar power generation plant, a power transmission facility, each home use, office, factory, regardless of electric path is whether alternating electric current or direct electric current, high or low of electric potential, presence or absence of insulator, mounting position.

### rn[Explanation of Numerals and Symbols]

- 1: charging and discharging circuit
- 2: capacitor (charge capacitor)
- 2A: anode end capacitor
- 2K: cathode end capacitor
- 3: change-over switch
- 4: discharge switch
- 5: series wiring
- 6: intermediate diode
- 7A: wiring between the anode and the capacitor
- 7K: wiring between the cathode and the capacitor
- 7D: wiring between the diode and the capacitor
- 8A: anode end outside electrode
- 8K: cathode end outside electrode
- 9A: anode parallel wiring
- 9K: cathode parallel wiring
- 10: diode for parallel
- 11: timer part
- 12: timer part 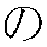 power supply terminal
- 13: timer power supply wiring
- 14: diode for power supply
- 20: electroscope (of 1st embodiment)
- 21: gate electrode
- 22: light-emitting part
- 23: rectifier
- 101: capacitor unit
- 102: electrode
- 102': coated electrode
- 102": metal plate
- 103: body part of electrode
- 104: non-parallel part of electrode
- 105: casing (of capacitor unit)
- 106: body side part of casing
- 107: joint side part of casing
- 110: electroscope (of 2nd embodiment)
- 111: light-emitting part
- 112: casing (of electroscope)
- 131: charging and discharging circuit
- 132: electric storage device
- 133: circuit board of charging and discharging circuit
- X: input electric current
- Y: output electric current
- J1: state that electric current is made to flow to plurality capacitor in series
- J2: state that electric current is made to flow to plurality capacitor in parallel
- R: electric path
- R': alternating electric path
- E: electric field
- L: longer direction of electric path

## Claims

1. A charging and discharging circuit, wherein
the charging and discharging circuit charges input electric current (X) to a plurality of capacitors (2), the charging and discharging circuit discharges output electric current (Y) from the plurality of the capacitors (2);
the charging and discharging circuit comprises change-over switches (3) which are switched to a series electric current state (J1), in which the electric current flows to the plurality of the capacitors (2) in series, and a parallel electric current state (J2), in which the electric current flows to the plurality of the capacitors (2) in parallel;
the charging and discharging circuit comprises, apart from the change-over switches (3), a discharge switch (4) configured to start a discharging of the output electric current (Y) from the plurality of the capacitors (2) too, **characterized by** the following;
the charging and discharging circuit comprises a series wiring (5) which connects to the plurality of the capacitors (2) in series;
the charging and discharging circuit comprises intermediate diodes (6) which are arranged between each set of adjacent two capacitors (2) and are aligned in a forward direction from an anode to a cathode in the series wiring (5);
the charging and discharging circuit comprises anode parallel wirings (9A) connecting each anode-capacitor interval (7A) between the anode side of the intermediate diode (6) and the capacitor adjacent to the anode side, to a cathode end outside electrode (8K) which is positioned on the end of the series wiring (5) and is positioned on the opposite side of the intermediate diode in a cathode end capacitor (2K) adjacent to only the cathode side of the intermediate diode (6);
the charging and discharging circuit comprises cathode parallel wirings (9K) connecting each cathode-capacitor interval (7K) between the cathode side of the intermediate diode (6) and the capacitor adjacent to the cathode side, to an anode end outside electrode (8A) which is positioned on the end of the series wiring (5) and is positioned on the opposite side of the intermediate diode in an anode end capacitor (2A) adjacent to only the anode side of the intermediate diode (6);
the charging and discharging circuit has
a case that the change-over switches (3) are arranged in the anode parallel wirings (9A), diodes for parallel (10) are arranged in a forward direction from the cathode-capacitor interval (7K) to the anode end outside electrode (8A) in the cathode parallel wirings (9K),
a case that the change-over switches (3) are arranged in the cathode parallel wirings (9K), diodes for parallel (10) are arranged in a forward direction from the cathode end outside electrode (8K) to the anode-capacitor interval (7A) in the anode parallel wirings (9A), or,
a case that the change-over switches (3) are arranged in the anode parallel wirings (9A) and the cathode parallel wirings (9K).

2. The charging and discharging circuit as claimed in claim 1, **characterized by** the following;
the charging and discharging circuit comprises a timer part (11) configured to periodically perform switching by the change-over switches (3) and starting by the discharge switch (4);
the charging and discharging circuit comprises a timer power supply wiring (13) connecting the power supply terminal (12) of the timer part (11) to a diode-capacitor interval (7D) between the cathode end capacitor (2K) or the anode end capacitor (2A) and the intermediate diode (6) adjacent to the capacitors (2K,2A);
the charging and discharging circuit comprises a diode for power supply (14) which is arranged in a forward direction from the diode-capacitor interval (7D) to the power supply terminal (12) in the timer power supply wiring (13).

3. An electroscope **characterized by** the following;
the electroscope comprises the charging and discharging circuit (1) described in claim 2, the electroscope is configured to inspect energization of electric path (R) using output electric current (Y) discharged from the charging and discharging circuit (1);
the electroscope comprises a pair of gate electrodes (21) configured to be connected to the anode end outside electrode (8A) and the cathode end outside electrode (8K) of the charging and discharging circuit (1);
the electroscope charges the input electric current (X) by electric potential difference between the one pair of gate electrodes (21) to the plurality of the capacitors (2), at the time of making the one pair of gate electrodes (21) positioned in electric field (E) generated by the energization of the electric path (R);
the electroscope comprises a light-emitting part (22) which flickers by the output electric current (Y) discharged periodically from the plurality of the capacitors (2).

4. The electroscope as claimed in claim 3, **characterized by** the following;
the electric path (R) is an alternating electric path (R');
the electroscope comprises rectifiers (23) configured to convert alternating electric current from the alternating electric path (R') to direct electric current;
the electroscope is configured to charge the direct electric current from the rectifiers (23) to the plurality of the capacitors (2) as the input electric current (X);
the electroscope is configured to switch the series electric current state (J1) at the time of charging to the plurality of the capacitors (2) by the change-over switches (3), the electroscope is configured to switch the parallel electric current state (J2) before discharging from the plurality of the capacitors (2) by the change-over switches (3);
the electroscope is configured to start to discharge the output electric current (Y) by the discharge switch (4) after switching the parallel electric current state (J2).

5. The electroscope as claimed in claims 3 or 4, **characterized by** the following;
the electroscope comprises a capacitor unit (101) having the one pair of electrodes (102), the electroscope is configured to charge the electric current of the capacitor unit (101) to the plurality of the capacitors (2) of the charging and discharging circuit (1) described in claim 3, the electroscope configured to inspect the energization of electric path (R);
both the electrodes (102) of the pair of the capacitor unit (101) respectively comprise a body part (103) being almost parallel mutually;
the one or the both of the one pair of the electrodes (102) comprise a non-parallel part (104) configured to stand toward the other electrode side on the end of the body part (103), and is not almost parallel to the other electrode.

## Patentansprüche

1. Lade- und Entladeschaltung, wobei
die Lade- und Entladeschaltung einen elektrischen Eingangsstrom (X) zu mehreren Kondensatoren (2) lädt, die Lade- und Entladeschaltung einen elektrischen Ausgangsstrom (Y) aus den mehreren Kondensatoren (2) entlädt;
die Lade- und Entladeschaltung Umschalter (3) umfasst, die zu einem seriellen elektrischen Stromzustand (J1), in dem der elektrische Strom zu den mehreren Kondensatoren (2) in Reihe fließt, und einen parallelen elektrischen Stromzustand (J2), in dem der elektrische Strom zu den mehreren Kondensatoren (2) parallel fließt, geschaltet werden;
die Lade- und Entladeschaltung neben den Umschaltern (3) einen Entladeschalter (4) umfasst, der dazu ausgelegt ist, auch eine Entladung des elektrischen Ausgangsstroms (Y) aus den mehreren Kondensatoren (2) zu starten, **gekennzeichnet durch** Folgendes;
die Lade- und Entladeschaltung umfasst eine Reihenverdrahtung (5), die mit den mehreren Kondensatoren (2) in Reihe geschaltet ist;
die Lade- und Entladeschaltung umfasst Zwischendioden (6), die zwischen jedem Satz von zwei benachbarten Kondensatoren (2) angeordnet sind und in einer Durchlassrichtung von einer Anode zu einer Kathode in der Reihenverdrahtung (5) ausgerichtet sind;
die Lade- und Entladeschaltung umfasst anodenparallele Verdrahtungen (9A), die jedes Anoden-Kondensator-Intervall (7A) zwischen der Anodenseite der Zwischendiode (6) und dem der Anodenseite benachbarten Kondensator mit einer äußeren Kathodenend-Elektrode (8K) verbinden, die am Ende der Reihenverdrahtung (5) positioniert ist und auf der gegenüberliegenden Seite der Zwischendiode in einem Kathodenend-Kondensator (2K) positioniert ist, der nur der Kathodenseite der Zwischendiode (6) benachbart ist;
die Lade- und Entladeschaltung umfasst kathodenparallele Verdrahtungen (9K), die jedes Kathoden-Kondensator-Intervall (7K) zwischen der Kathodenseite der Zwischendiode (6) und dem der Kathodenseite benachbarten Kondensator mit einer äußeren Anodenend-Elektrode (8A) verbinden, die am Ende der Reihenverdrahtung (5) positioniert ist und auf der gegenüberliegenden Seite der Zwischendiode in einem Anodenend-Kondensator (2A) positioniert ist, der nur der Anodenseite der Zwischendiode (6) benachbart ist;
die Lade- und Entladeschaltung
weist einen Fall auf, in dem die Umschalter (3) in den anodenparallelen Verdrahtungen (9A) angeordnet sind, Dioden für die Parallelschaltung (10) in einer Durchlassrichtung vom Kathoden-Kondensator-Intervall (7K) zur äußeren Anodenend-Elektrode (8A) in den kathodenparallelen Verdrahtungen (9K) angeordnet sind, weist einen Fall auf, in dem die Umschalter (3) in den Kathoden-Parallelverdrahtungen (9K) angeordnet sind, Dioden für die Parallelschaltung (10) in einer Durchlassrichtung von der äußeren Kathodenend-Elektrode (8K) zum Anoden-Kondensator-Intervall (7A) in den Anoden-Parallelverdrahtungen (9A) angeordnet sind, oder, weist einen Fall auf, in dem die Umschalter (3) in den anodenparallelen Verdrahtungen (9A) und den kathodenparallelen Verdrahtungen (9K) angeordnet sind.

2. Lade- und Entladeschaltung nach Anspruch 1, **gekennzeichnet durch** Folgendes;
die Lade- und Entladeschaltung umfasst einen Zeitgeberteil (11), der dazu ausgelegt ist, das Umschalten durch die Umschalter (3) und das Starten durch den Entladeschalter (4) periodisch durchzuführen;
die Lade- und Entladeschaltung umfasst eine Zeitgeber-Stromversorgungsverdrahtung (13), die den Stromversorgungsanschluss (12) des Zeitgeberteils (11) mit einem Dioden-Kondensator-Intervall (7D) zwischen dem Kathodenend-Kondensator (2K) oder dem Anodenend-Kondensator (2A) und der den Kondensatoren (2K, 2A) benachbarten Zwischendiode (6) verbindet;
die Lade- und Entladeschaltung umfasst eine Diode für die Stromversorgung (14), die in Vorwärtsrichtung vom Dioden-Kondensator-Intervall (7D) zum Stromversorgungsanschluss (12) in der Zeitgeber-Stromversorgungsverdrahtung (13) angeordnet ist.

3. Elektroskop, **gekennzeichnet durch** Folgendes;
das Elektroskop umfasst die in Anspruch 2 beschriebene Lade- und Entladeschaltung (1), das Elektroskop ist dazu ausgelegt, die Erregung des elektrischen Pfades (R) unter Verwendung des von der Lade- und Entladeschaltung (1) entladenen elektrischen Ausgangsstroms (Y) zu überprüfen;
das Elektroskop umfasst ein Paar von Gate-Elektroden (21), die dazu ausgelegt sind, mit der äußeren Anodenend-Elektrode (8A) und der äußeren Kathodenend-Elektrode (8K) der Lade- und Entladeschaltung (1) verbunden zu werden;
das Elektroskop lädt den elektrischen Eingangsstrom (X) durch die elektrische Potentialdifferenz zwischen dem einen Paar von Gate-Elektroden (21) zu den mehreren Kondensatoren (2) auf, wenn das eine Paar von Gate-Elektroden (21) in einem elektrischen Feld (E) positioniert wird, das durch die Erregung des elektrischen Pfades (R) erzeugt wird;
das Elektroskop umfasst einen lichtemittierenden Teil (22), der durch den elektrischen Ausgangsstrom (Y) flackert, der periodisch von den mehreren Kondensatoren (2) entladen wird.

4. Elektroskop nach Anspruch 3, **gekennzeichnet durch** Folgendes:
der elektrische Pfad (R) ist ein alternierender elektrischer Pfad (R');
das Elektroskop umfasst Gleichrichter (23), die dazu ausgelegt sind, elektrischen Wechselstrom aus dem elektrischen Wechselstrompfad (R') in elektrischen Gleichstrom umzuwandeln;
das Elektroskop ist dazu ausgelegt, den elektrischen Gleichstrom von den Gleichrichtern (23) auf die mehreren Kondensatoren (2) als elektrischen Eingangsstrom (X) zu laden;
das Elektroskop ist dazu ausgelegt, den seriellen elektrischen Stromzustand (J1) zum Zeitpunkt des Aufladens der mehreren Kondensatoren (2) durch die Umschalter (3) umzuschalten, das Elektroskop ist dazu ausgelegt, den parallelen elektrischen Stromzustand (J2) vor dem Entladen aus den mehreren Kondensatoren (2) durch die Umschalter (3) umzuschalten;
das Elektroskop ist dazu ausgelegt, nach dem Umschalten des parallelen Stromzustands (J2) das Entladen des elektrischen Ausgangsstroms (Y) durch den Entladeschalter (4) zu starten.

5. Elektroskop nach Anspruch 3 oder 4, **gekennzeichnet durch** Folgendes;
das Elektroskop umfasst eine Kondensatoreinheit (101) mit dem einen Elektrodenpaar (102), das Elektroskop ist dazu ausgelegt, den elektrischen Strom der Kondensatoreinheit (101) in die mehreren Kondensatoren (2) der in Anspruch 3 beschriebenen Lade- und Entladeschaltung (1) zu laden, das Elektroskop ist dazu ausgelegt, die Versorgung des elektrischen Pfades (R) zu überprüfen;
die beiden Elektroden (102) des Paares der Kondensatoreinheit (101) umfassen jeweils einen Körperteil (103), der zum jeweiligen anderen nahezu parallel ist;
die eine oder die beiden des einen Paares der Elektroden (102) umfassen einen nicht parallelen Teil (104), der dazu ausgelegt ist, in Richtung der anderen Elektrodenseite am Ende des Körperteils (103) zu stehen, und nicht nahezu parallel zu der anderen Elektrode ist.

## Revendications

1. Circuit de charge et de décharge, dans lequel :
le circuit de charge et de décharge charge un courant électrique d'entrée (X) sur une pluralité de condensateurs (2), le circuit de charge et de décharge décharge un courant électrique de sortie (Y) depuis la pluralité des condensateurs (2) ;
le circuit de charge et de décharge comprend des commutateurs (3) qui sont commutés dans un état de courant électrique série (J1), dans lequel le courant électrique circule vers la pluralité des condensateurs (2) en série, et dans un état de courant électrique parallèle (J2), dans lequel le courant électrique circule vers la pluralité des condensateurs (2) en parallèle ;
le circuit de charge et de décharge comprend, outre les commutateurs (3), un commutateur de décharge (4) configuré pour aussi démarrer une décharge du courant électrique de sortie (Y) depuis la pluralité des condensateurs (2), **caractérisé par** les éléments suivants :
le circuit de charge et de décharge comprend un câblage en série (5) qui se connecte à la pluralité des condensateurs (2) en série ;
le circuit de charge et de décharge comprend des diodes intermédiaires (6) qui sont disposées entre chaque ensemble de deux condensateurs adjacents (2) et qui sont alignées dans une direction avant d'une anode à une cathode dans le câblage en série (5) ;
le circuit de charge et de décharge comprend des câblages parallèles d'anode (9A) connectant chaque intervalle anode-condensateur (7A) entre le côté anode de la diode intermédiaire (6) et le condensateur adjacent au côté anode, à une électrode extérieure d'extrémité de cathode (8K) qui est positionnée sur l'extrémité du câblage série (5) et est positionnée sur le côté opposé de la diode intermédiaire dans un condensateur d'extrémité de cathode (2K) adjacent uniquement au côté cathode de la diode intermédiaire (6) ;
le circuit de charge et de décharge comprend des câblages parallèles de cathode (9K) connectant chaque intervalle cathode-condensateur (7K) entre le côté cathode de la diode intermédiaire (6) et le condensateur adjacent au côté cathode, à une électrode extérieure d'extrémité d'anode (8A) qui est positionnée sur l'extrémité du câblage série (5) et est positionnée sur le côté opposé de la diode intermédiaire dans un condensateur d'extrémité d'anode (2A) adjacent au seul côté anode de la diode intermédiaire (6) ;
le circuit de charge et de décharge présente :
un cas où les commutateurs (3) sont disposés dans les câblages parallèles d'anode (9A), les diodes pour le montage parallèle (10) sont disposées dans une direction avant de l'intervalle cathode-condensateur (7K) vers l'électrode extérieure d'extrémité d'anode (8A) dans les câblages parallèles de cathode (9K),
un cas où les commutateurs (3) sont disposés dans les câblages parallèles de cathode (9K), les diodes pour le montage parallèle (10) sont disposées dans une direction avant de l'électrode extérieure d'extrémité de cathode (8K) vers l'intervalle de condensateur d'anode (7A) dans les câblages parallèles d'anode (9A), ou
un cas où les commutateurs (3) sont disposés dans les câblages parallèles d'anode (9A) et les câblages parallèles de cathode (9K).

2. Circuit de charge et de décharge tel que revendiqué dans la revendication 1, **caractérisé par** les éléments suivants :
le circuit de charge et de décharge comprend une partie minuterie (11) configurée pour effectuer périodiquement une commutation par les commutateurs (3) et un démarrage par le commutateur de décharge (4) ;
le circuit de charge et de décharge comprend un câblage d'alimentation de minuterie (13) connectant la borne d'alimentation (12) de la partie minuterie (11) à un intervalle diode-condensateur (7D) entre le condensateur d'extrémité de cathode (2K) ou le condensateur d'extrémité d'anode (2A) et la diode intermédiaire (6) adjacente aux condensateurs (2K, 2A) ;
le circuit de charge et de décharge comprend une diode pour l'alimentation électrique (14) qui est disposée dans une direction avant de l'intervalle diode-condensateur (7D) vers la borne d'alimentation électrique (12) dans le câblage d'alimentation électrique de la minuterie (13).

3. Électroscope **caractérisé par** les éléments suivants :
l'électroscope comprend le circuit de charge et de décharge (1) décrit dans la revendication 2, l'électroscope est configuré pour inspecter l'excitation du chemin électrique (R) au moyen du courant électrique de sortie (Y) déchargé du circuit de charge et de décharge (1) ;
l'électroscope comprend une paire d'électrodes de grille (21) configurées pour être connectées à l'électrode extérieure d'extrémité d'anode (8A) et à l'électrode extérieure d'extrémité de cathode (8K) du circuit de charge et de décharge (1) ;
l'électroscope charge le courant électrique d'entrée (X) par différence de potentiel électrique entre la paire d'électrodes de grille (21) vers la pluralité de condensateurs (2), au moment où la paire d'électrodes de grille (21) est positionnée dans le champ électrique (E) généré par l'excitation du chemin électrique (R) ;
l'électroscope comprend une partie émettrice de lumière (22) qui scintille du fait du courant électrique de sortie (Y) déchargé périodiquement depuis la pluralité de condensateurs (2).

4. Électroscope tel que revendiqué dans la revendication 3, **caractérisé par** les éléments suivants :
le chemin électrique (R) est un chemin électrique alternatif (R') ;
l'électroscope comprend des redresseurs (23) configurés pour convertir le courant électrique alternatif du chemin électrique alternatif (R') en courant électrique continu ;
l'électroscope est configuré pour charger le courant électrique continu des redresseurs (23) dans la pluralité de condensateurs (2) comme courant électrique d'entrée (X) ;
l'électroscope est configuré pour commuter l'état de courant électrique série (J1) au moment de la charge de la pluralité de condensateurs (2) par les commutateurs (3), l'électroscope est configuré pour commuter l'état de courant électrique parallèle (J2) avant la décharge depuis la pluralité de condensateurs (2) par les commutateurs (3) ;
l'électroscope est configuré pour commencer la décharge du courant électrique de sortie (Y) par le commutateur de décharge (4) après la commutation de l'état de courant électrique parallèle (J2).

5. Électroscope tel que revendiqué dans la revendication 3 ou la revendication 4, **caractérisé par** les éléments suivants :
l'électroscope comprend une unité de condensateur (101) ayant une paire d'électrodes (102), l'électroscope est configuré pour charger le courant électrique de l'unité de condensateur (101) vers la pluralité de condensateurs (2) du circuit de charge et de décharge (1) décrit dans la revendication 3, l'électroscope est configuré pour inspecter l'excitation du chemin électrique (R) ;
les deux électrodes (102) de la paire de l'unité de condensateur (101) comprennent respectivement une partie de corps (103), qui sont mutuellement presque parallèles ;
l'une ou les deux électrodes de la paire d'électrodes (102) comprennent une partie non parallèle (104) configurée pour se tenir vers l'autre côté d'électrode sur l'extrémité de la partie de corps (103), et n'est pas presque parallèle à l'autre électrode.
